(19) Europäisches Patentamt
European Patent Office
Office européen des brevets

(11) EP 4 579 344 A1

(12) **EUROPEAN PATENT APPLICATION**

(43) Date of publication:
**02.07.2025 Bulletin 2025/27**

(21) Application number: **23220773.8**

(22) Date of filing: **29.12.2023**

(51) International Patent Classification (IPC):
***G03F 7/031*** *(2006.01)* ***G03F 7/029*** *(2006.01)*
***C08F 2/50*** *(2006.01)*

(52) Cooperative Patent Classification (CPC):
**G03F 7/029; C08F 2/50; G03F 7/031**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **IGM Group B.V.**
**5145 RM Waalwijk (NL)**

(72) Inventors:
- **MORONE, Marika**
  **22030 Lipomo (IT)**
- **FREDERICO, Stefano**
  **22100 Como (IT)**

(74) Representative: **Maiwald GmbH**
**Elisenhof**
**Elisenstraße 3**
**80335 München (DE)**

(54) **THIOALKYLCOUMARIN PHOTOSENSITIZERS FOR PHOTOPOLYMERIZATION**

(57) A photopolymerizable composition (PC) comprising:
a) one or more ethylenically unsaturated, free-radical polymerizable compounds;
b) one or more photoinitiators (PI);
c) one or more thioalkyl coumarin photo sensitizers (S).

EP 4 579 344 A1

## Description

### Field of the Invention

The present invention relates to a photopolymerizable composition comprising one or more one or more ethylenically unsaturated, free-radical polymerizable compounds, one or more photoinitiators, and one or more thioalkylcoumarin photosensitizers, exemplary thioalkylcoumarin photosensitizers, a method for polymerizing the photopolymerizable composition, a use of the thioalkylcoumarin photosensitizers for improving the performance of Norrish Type-I photoinitiators, and a use of one or more Norrish Type-I photoinitiators in combination with one or more thioalkylcoumarin photosensitizers in the production of various photopolymerized products.

### Background to the Invention

Photoinitiators for promoting the radical polymerisation of ethylenically unsaturated compounds may be classed as either Norrish Type-I, wherein an electronically excited photoinitiator fractures to form a free radical that acts to initiate the radical polymerisation, or Norrish Type-II, wherein an electronically excited photoinitiator abstracts a hydrogen radical from a further molecule to form a free radical from said further molecule, said free radical acting to initiate the radical polymerisation. Whilst Type-II photoinitiators require the presence of certain additives/co-initiators, these additives/coinitiators are not generally required for Type-I photoinitiators.

The development of new Type-I photoinitiators is a key area of research in the field of resin curing. In addition to the provision of novel Type-I photoinitiators, the provision of Type-I photoinitiator packages, wherein the activity of the Type-I photoinitiator is enhanced by the presence of other compounds, such as photosensitizers. These compounds absorb light at a different wavelength to that of the photoinitiator itself and transfer energy to the photoinitiator, improving the energy absorption by the photoinitiator.

Whilst such photosensitizer compounds are known to be effective, many can have undesired side effects, such as a yellowing of the resultant photopolymerized compositions. Furthermore, not all photosensitizers are compatible with all photoinitiators. Consequently the continued development of new photosensitizer compounds is a key area of development that goes hand in hand with the development of new photoinitiators.

### Summary of the Invention

The present observation is based on the observation that thioalkylcoumarin compounds may be used as effective photosensitizers without many of the downsides of other well-known photosensitizers.

The present invention, in a first aspect, is thus directed to a photopolymerizable composition (PC) comprising:

a) one or more ethylenically unsaturated, free-radical polymerizable compounds;
b) one or more photoinitiators (PI);
c) one or more photosensitizers (S) having a structure according to formula (I)

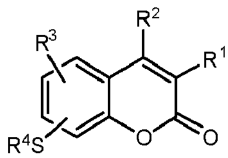

(I)

wherein $R^1$ and $R^2$ are independently selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl, wherein $R^3$ represents from 0 to 3 substitutions, each being selected from the group consisting of hydrogen, halogen, $C_1$-$C_{10}$ alkyl, $C_6$-$C_{14}$ aryl, $OR^5$, $SR^5$, and $NR^5_2$, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl, wherein $R^4$ is selected from the group consisting of $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,

wherein at least one of $R^1$ and $R^2$ is not hydrogen, and
wherein each instance of $R^1$ to $R^5$ may optionally be joined to one or more further instances of $R^1$ to $R^5$ to form one or more 5-membered or 6-membered rings.

In a second aspect, the present invention is directed to a compound selected from the group consisting of:

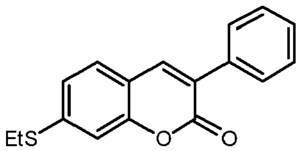
,
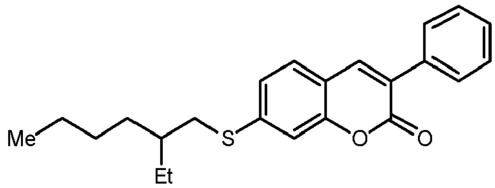
,

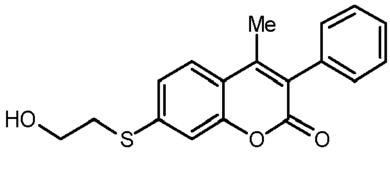
,
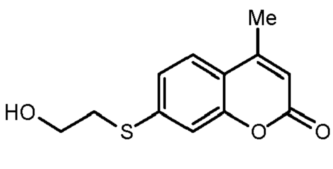
,
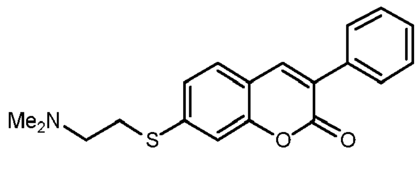
,

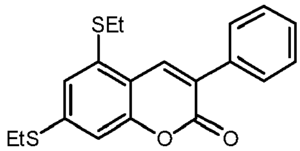
, and
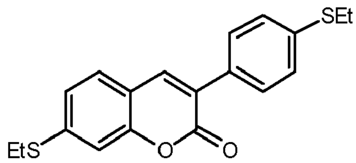
.

In a third aspect, the present invention is directed to a method for photocuring photopolymerizable compositions, coatings, adhesives and inks, said method comprising the following steps in the given order:

a) coating or printing the photopolymerizable composition (PC) according to any one of the preceding claims onto a substrate, and
b) photopolymerizing said coated or printed composition with a light source on said substrate.

In a fourth aspect, the present invention is directed to a use of a compound having a structure according to formula (I)

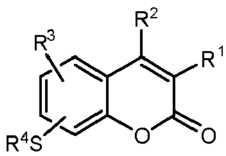
(I)

wherein $R^1$ and $R^2$ are independently selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein $R^3$ represents from 0 to 3 substitutions, each being selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein $R^4$ is selected from the group consisting of $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein at least one of $R^1$ and $R^2$ is not hydrogen, and

wherein each instance of $R^1$ to $R^5$ may optionally be joined to one or more further instances of $R^1$ to $R^5$ to form one or more 5-membered or 6-membered rings,
for improving the performance of one or more Norrish Type-I photoinitiators.

In a final aspect, the present invention is directed to a use of one or more Norrish Type-I photoinitiators in combination with one or more compounds having a structure according to formula (I)

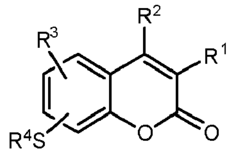 (I)

wherein $R^1$ and $R^2$ are independently selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein $R^3$ represents from 0 to 3 substitutions, each being selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein $R^4$ is selected from the group consisting of $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein at least one of $R^1$ and $R^2$ is not hydrogen, and
wherein each instance of $R^1$ to $R^5$ may optionally be joined to one or more further instances of $R^1$ to $R^5$ to form one or more 5-membered or 6-membered rings,
in the production of printing inks, screen-printing inks, gravure printing inks, solder masks, etch offset-printing inks, flexographic- printing inks, gravure printing inks, inkjet inks, resist material, insulators, encapsulants, image-recording material, solder mask, passivation layer, protective coating, 3D-printing objects and molds, holographic applications, optical fiber coating, waveguide and lens, overprint varnish, wood, vinyl, metal and plastic coatings.

## Definitions

In the present description the expressions "alkyl" or "alkyl group" mean, where not differently indicated, a linear or branched, saturated alkyl chain containing the given number of carbon atoms and includes all possibilities for each number of carbon atoms in the alkyl group, i.e. for three carbon atoms: n-propyl and i-propyl; for four carbon atoms: n-butyl, i-butyl, s-butyl and t-butyl etc..

The expressions "aryl" or "aryl group" include, for example, a substituted or unsubstituted aryl group, such as a substituted or unsubstituted phenyl group, a substituted or unsubstituted naphthyl group, an anthracenyl group, an indenyl group, a fluorenyl group.

The expressions "heteroaryl" or "heteroaryl group" include, for example, a substituted or unsubstituted heteroatom-containing aromatic ring system, such as pyridine, pyrrole, furan, triazine, indole, quinolone, thiophene etc.

The expression "$C_1$-$C_{40}$ alkyl which is interrupted by one or more oxygens" means that, in case more than one oxygen atom is present, said oxygen atoms are separated from one another by at least one methylene group, i.e. the oxygen atoms are non-consecutive. Examples include the following: - $OCH_2OCH_3$, $-OCH_2CH_2OCH_2CH_3$, $-O[CH_2CH_2O]_vCH_3$, $-O[CH_2CH_2O]_vOH$, - $O[CH_2CH_2O]_vCH_2CH_3$, $-CH_2O[CH_2CH_2O]_vCH_3$ with v=1-19, $-O[CH_2CH_2CH_2O]_pOH$, $-O[CH_2CH_2CH_2O]_pCH_3$, $-O[CH_2CH_2CH_2O]_pCH_2CH_3$, - $CH_2O[CH_2CH_2CH_2O]_pCH_3$ with p=1-12.

When a group is substituted, the term "substituted" means that said group bears one or more substituents, said substituents being preferably selected from halogen atom, alkyl, cycloalkyl, alkoxy, alkylamino, dialkylamino, alkylthio or arylthio group, heterocyclic groups; more preferably selected from methyl, ethyl, isopropyl, tert-butyl, phenyl, trifluoromethyl, cyano, acetyl, ethoxycarbonyl, carboxyl, carboxylate, amino, methylamino, dimethylamino, ethylamino, diethylamino, isopropylamino, diisopropylamino, cyclohexylamino, dicyclohexylamino, acetylamino, piperidino, pyrrolidyl, methoxy, ethoxy, propoxy, isopropoxy, butoxy, pentyloxy, phenoxy, hydroxyl, acetoxy, - $PO_3H$, methylthio, ethylthio, i-propylthio, n-propylthio, phenyltio, mercapto, acetylthio, thiocyano, methylsulfinyl, methylsulfonyl, dimethylsulfonyl,

sulfonate groups, fluorine atom, chlorine atom, bromine atom, iodine atom, trimethylsilyl, pentamethyldisilyl, triethylsilyl, trimethylstannyl, furyl, thienyl, pyridyl and morpholino.

A methylene group refers to an $sp^3$ hybridised carbon connected to two hydrogen groups, i.e. $-CH_2F$, whilst a methanetriyl group refers to an $sp^3$ hybridised carbon connrected to one hydrogen group, i.e. - $CHR_2$.

Photoinitiators may be classed as either Norrish Type-I, wherein an electronically excited photoinitiator fractures to form a free radical that acts to initiate the radical polymerisation, or Norrish Type-II, wherein an electronically excited photoinitiator abstracts a hydrogen radical from a further molecule to form a free radical from said further molecule, said free radical acting to initiate the radical polymerisation, as is well understood by the person skilled in the art.

## Detailed Description

The photopolymerizable composition (PC) according to the first aspect comprises:

a) one or more ethylenically unsaturated, free-radical polymerizable compounds;
b) one or more photoinitiators (PI);
c) one or more photosensitizers (S) having a structure according to formula (I).

The photopolymerizable composition (PC) may further comprise one or more of the following components:

d) one or more one or more further photosensitizers having a structure other than formula (I);
e) one or more amines;
f) one or more pigments;
g) one or more binders;
h) one or more additives.

The photopolymerizable composition (PC) preferably comprises:

a) an amount in the range from 30 to 99.0 wt.-%, more preferably in the range from 50 to 95.0 wt.-%, most preferably in the range from 70 to 90 wt.-%, relative to the total weight of the photopolymerizable composition, of the one or more ethylenically unsaturated, free-radical polymerizable compounds;
b) an amount in the range from 0.5 to 25.0 wt.-%, more preferably in the range from 0.8 to 20.0 wt.-%, most preferably in the range from 1.0 to 15.0 wt.-%, relative to the total weight of the photopolymerizable composition, of the one or more photoinitiators (PI);
c) an amount in the range from 0.1 to 10.0 wt.-%, more preferably in the range from 0.2 to 8.0 wt.-%, most preferably in the range from 0.3 to 6.0 wt.-%, relative to the total weight of the photopolymerizable composition, of the one or more photosensitizers (S) having a structure according to formula (I).

In one preferred embodiment, the photopolymerizable composition (PC) comprises:

a) an amount in the range from 30 to 99.0 wt.-%, relative to the total weight of the photopolymerizable composition, of the one or more ethylenically unsaturated, free-radical polymerizable compounds;
b) an amount in the range from 0.5 to 25.0 wt.-%, relative to the total weight of the photopolymerizable composition, of the one or more photoinitiators (PI);
c) an amount in the range from 0.1 to 10.0 wt.-%, relative to the total weight of the photopolymerizable composition, of the one or more photosensitizers (S) having a structure according to formula (I).

In a further preferred embodiment, the photopolymerizable composition (PC) comprises:

a) an amount in the range from 50 to 95.0 wt.-%, relative to the total weight of the photopolymerizable composition, of the one or more ethylenically unsaturated, free-radical polymerizable compounds;
b) an amount in the range from 0.8 to 20.0 wt.-%, relative to the total weight of the photopolymerizable composition, of the one or more photoinitiators (PI);
c) an amount in the range from 0.2 to 8.0 wt.-%, relative to the total weight of the photopolymerizable composition, of the one or more photosensitizers (S) having a structure according to formula (I).

In an even further preferred embodiment, the photopolymerizable composition (PC) comprises:

a) an amount in the range from 70 to 90 wt.-%, relative to the total weight of the photopolymerizable composition, of the

one or more ethylenically unsaturated, free-radical polymerizable compounds;
b) an amount in the range from 1.0 to 15.0 wt.-%, relative to the total weight of the photopolymerizable composition, of the one or more photoinitiators (PI);
c) an amount in the range from 0.3 to 6.0 wt.-%, relative to the total weight of the photopolymerizable composition, of the one or more photosensitizers (S) having a structure according to formula (I).

In each of these embodiments, the photopolymerizable composition (PC) may further comprise:

d) an amount in the range from 0.1 to 10.0 wt.-%, more preferably in the range from 0.3 to 5.0 wt.-%, most preferably in the range from 0.5 to 3.0 wt.-% of one or more further photosensitizers having a structure other than formula (I);
e) an amount in the range from 0.1 to 10.0 wt.-%, more preferably in the range from 0.3 to 5.0 wt.-%, most preferably in the range from 0.5 to 3.0 wt.-% of one or more amines;
f) an amount in the range from 0.1 to 30 wt.-%, more preferably in the range from 1.0 to 25 wt.-%, most preferably in the range from 10 to 20 wt.-%, relative to the total weight of the photopolymerizable composition, of one or more pigments;
g) an amount in the range from 5.0 to 60 wt.-%, more preferably in the range from 8.0 to 50 wt.-%, most preferably in the range from 10 to 40 wt.-%, relative to the total weight of the photopolymerizable composition, of one or more binders; and
h) an amount in the range from 0.01 to 10 wt.-%, more preferably in the range from 0.01 to 8.0 wt.-%, most preferably in the range from 0.01 to 5.0 wt.-%, relative to the total weight of the photopolymerizable composition, of one or more additives.

In addition to the above components, one or more solvents, such as water and/or organic solvents, may be employed. If solvents are employed, then all of the wt.-% ranges given above and below are expressed relative to the total weight of the photopolymerizable composition excluding the weight of the solvent.
The individual components will now be described in more detail.

**The one or more ethylenically unsaturated, free-radical polymerizable compounds**

One of the essential components of the photopolymerizable composition (PC) according to the present invention is one or more ethylenically unsaturated, free-radical polymerizable compounds.
The choice of the one or more ethylenically unsaturated, free-radical polymerizable compounds is not particularly limited. Said polymerizable compounds can contain one or more olefinic double bonds. They can be low-molecular weight (monomeric) or high-molecular weight (oligomeric) compounds.
Examples of suitable low molecular weight polymerizable compounds (monomeric compounds) having one double bond are alkyl or hydroxyalkyl acrylates or methacrylates, such as methyl-, ethyl-, butyl-, 2-ethylhexyl-,2-hydroxyethyl- or isobornyl-acrylate; and methyl or ethyl methacrylate. Further examples 5 are resins modified with silicon or fluorine, e.g. silicone acrylates. Further examples of these polymerizable compounds are acrylonitrile, acrylamide, methacrylamide, N-substituted (meth)acrylamides, styrene, alkylstyrenes and halogeno styrenes, vinyl esters such as vinyl acetate, vinyl ethers such as iso-butyl vinyl ether, N-vinylpyrrolidone, vinyl chloride or vinylidene chloride.
Examples of polymerizable compounds having more than one double bond are the ethylene glycol diacrylate, propylene glycol diacrylate, neopentyl glycol diacrylate, hexamethylene glycol diacrylate, bisphenol A diacrylate, 4,4'-bis-(2-acryloyloxyethoxy)-diphenylpropane, trimethylolpropane triacrylate, pentaerythritol triacrylate or tetraacrylate, vinyl acrylate, divinyl benzene, divinyl succinate, diallyl phthalate, triallyl phosphate, triallyl isocyanurate or tris-(2-acryloylethyl) isocyanurate.
Examples of high-molecular weight (oligomeric) polyunsaturated compounds are acrylated epoxy resins, acrylated or vinyl-ether- or epoxy-group-containing polyesters, acrylated polyurethanes or acrylated polyethers.
Further examples of unsaturated oligomers are unsaturated polyester resins which are usually prepared from maleic acid, phthalic acid and one or more diols and which have molecular weights of from about 500 Da to 3,000 Da. Such unsaturated oligomers can also be referred to as prepolymers.
Examples of polymerizable compounds which are particularly suitable for the implementation of the present invention, are esters of ethylenically unsaturated carboxylic acids and polyols or polyepoxides, and polymers containing ethylenically unsaturated groups in the chain or in side groups, e.g. unsaturated polyesters, polyamides and polyurethanes and copolymers thereof, alkyl resins, polybutadiene and butadiene copolymers, polyisoprene and isoprene copolymers, polymers and copolymers having (meth)acrylic groups in side chains, as well as mixtures thereof.
Illustrative examples of unsaturated carboxylic acids or anhydrides, useful for the preparation of the above esters, are acrylic acid, methacrylic acid, maleic anhydride, crotonic acid, itaconic acid, cinnamic acid and unsaturated fatty acids such as linolenic acid and oleic acid. Acrylic and methacrylic acid are preferred.
Examples of polyols, which can also be esterified, are aromatic and aliphatic and cycloaliphatic polyols,

preferably aliphatic and cycloaliphatic polyols. Aromatic polyols are, for example, hydroquinone, 4,4'-dihydroxydiphenyl, 2,2-di(4-hydroxyphenyl) propane, as well as novolaks and resoles.

Polyepoxides, which can be esterified, include those based on the said polyols, especially the reaction products between aromatic polyols and epichlorohydrin. Also suitable as polyols are polymers and copolymers that contain hydroxyl groups in the polymer chain or in side groups, for example polyvinyl alcohol and copolymers thereof or polymethacrylic acid hydroxyalkyl esters or copolymers thereof. Further suitable polyols are oligoesters carrying hydroxyl terminal groups.

Examples of aliphatic and cycloaliphatic polyols include alkylenediols containing preferably from 2 to 12 carbon atoms, such as ethylene glycol, 1,2- or 1,3-propanediol, 1,2-, 1,3- or 1,4-butanediol, pentanediol, hexanediol, octanediol, dodecanediol, diethylene glycol, triethylene glycol, polyethylene glycols having molecular weights of preferably from 200 Da to 1,500 Da, 1,3-cyclopentanediol, 1,2-, 1,3- or 1,4-cyclohexanediol, 1,4-dihydroxymethyl cyclohexane, glycerol, tris(β-hydroxy-ethyl)amine, trimethylolethane, trimethylolpropane, pentaerythritol, dipentaerythritol and sorbitol.

Further suitable ethylenically unsaturated compounds are unsaturated polyamides obtained from unsaturated carboxylic acids and aromatic, aliphatic and cycloaliphatic polyamines having preferably from 2 to 6, preferably from 2 to 4, amino groups. Examples of such polyamines are: ethylenediamine, 1,2- or 1,3-propylenediamine, 1,2-, 1,3- or 1,4-butylenediamine, 1,5-pentylenediamine, 1,6-hexylenediamine, octylenediamine, dodecylene diamine, 1,4-diaminocyclohexane, isophoronediamine, phenylene diamine, bisphenylenediamine, di-( β -aminoethyl) ether, diethylene triamine, triethylenetetramine and di(β -aminoethoxy)- and di(β -aminopropoxy)ethane. Other suitable polyamines are polymers and copolymers which may contain additional amino groups in the side chain and oligoamides containing amino end groups.

Specific examples of such unsaturated polyamides are methylenebisacrylamide, 1,6-hexamethylene bisacrylamide, diethylenetriamine trismethacrylamide, bis(methacrylamidopropoxy) ethane and N-[( β -hydroxyethoxy)ethyl] -acrylamide.

Unsaturated polyurethanes are also suitable for the implementation of the present invention as polymerizable compounds, for example those derived from saturated or unsaturated diisocyanates and unsaturated or saturated diols.

Polybutadiene and polyisoprene and copolymers thereof may also be used.

Suitable polymerizable compounds include, for example, olefins, such as ethylene, propene, butene and hexene, (meth)acrylates, acrylonitrile, styrene and vinyl chloride. Polymers having unsaturated (meth)acrylate groups in the side chain can also be used as the one or more ethylenically unsaturated, free-radical polymerizable compounds. They may typically be reaction products of epoxy resins based on novolac with (meth)acrylic acid; homo- or copolymers of vinyl alcohol or hydroxyalkyl derivatives thereof that have been esterified with (meth)acrylic acid; and homo- and copolymers of (meth)acrylates that have been esterified with hydroxyalkyl (meth)acrylates.

The one or more ethylenically unsaturated, free-radical polymerizable compounds are preferably present in a total amount in the range from 30 to 99.0 wt.-%, more preferably in the range from 50 to 95.0 wt.-%, most preferably in the range from 70 to 90 wt.-%, relative to the total weight of the photopolymerizable composition (PC).

**The one or more photoinitiators (PI)**

Another of the essential components of the photopolymerizable composition (PC) according to the present invention is one or more photoinitiators (PI).

In the broadest sense, any photoinitiator may be used, for example Norrish Type-I, Norrish Type-II, or cationic photoinitiators; however, it is preferred that at least one of the one or more photoinitiators (PI) is Norrish Type-I photoinitiator.

More preferably, at least one of the one or more photoinitiators (PI) is an acylphosphine oxide photoinitiator, such as a mono- or bisacylphosphine oxide photoiniator.

If at least one of the one or more photoinitiators (PI) is a monoacylphosphine oxide photoinitiator, then it is preferred that at least one, preferably all, of said monoacylphosphine oxide photoinitiators has a structure according to formula (XVII)

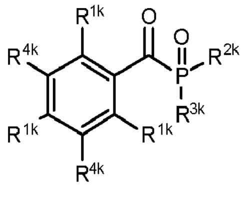

(XVII)

wherein each instance of $R^{1k}$ is independently selected from the group consisting of $C_1$-$C_4$ alkyl; wherein $R^{2k}$ is

selected from the group consisting of $C_1$-$C_{10}$ alkyl, $C_6$-$C_{10}$ aryl and combinations thereof,
wherein $R^{3k}$ is selected from the group consisting of $C_6$-$C_{10}$ aryl and $OR^{5k}$;
wherein each $R^{4k}$ is independently selected from the group consisting of hydrogen, $C_1$-$C_4$ alkyl, and $C(O)R^{6k}$;
wherein $R^{5k}$ is selected from the group consisting of hydrogen, $C_1$-$C_{40}$ alkyl and interrupted $C_2$-$C_{40}$ alkyl being interrupted by one or more O or $C_3$-$C_8$ cycloalkylene, wherein said $C_1$-$C_{40}$ alkyl or interrupted $C_2$-$C_{40}$ alkyl may be unsubstituted or substituted by one or more groups selected from OH and $R^{7k}$;
wherein $R^{6k}$ is selected from the group consisting of $C_1$-$C_4$ alkyl, $C_6$-$C_{10}$ aryl and combinations thereof;
wherein $R^{7k}$ is

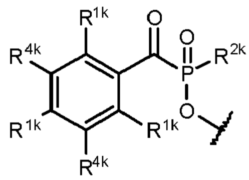

.

Each instance of $R^{1k}$ may be independently selected from the group consisting of $C_1$-$C_4$ alkyl, i.e. from methyl, ethyl, n-propyl, i-propyl, n-butyl, s-butyl, i-butyl and t-butyl. It is particularly preferred that each instance of $R^{1k}$ is selected from methyl and ethyl. Most preferably, each instance of $R^{1k}$ is methyl.

$R^{2k}$ is preferably selected from the group consisting of $C_1$-$C_4$ alkyl, phenyl, and combinations thereof. Most preferably, $R^{2k}$ is phenyl.

$R^{3k}$ is preferably selected from the group consisting of phenyl and $OR^{5k}$, most preferably $R^{3k}$ is $OR^{5k}$.

Each $R^{4k}$ is preferably independently selected from the group consisting of hydrogen and $C(O)R^{6k}$. Most preferably, each $R^{4k}$ is hydrogen.

$R^{6k}$ is preferably selected from the group consisting of $C_1$-$C_4$ alkyl, phenyl, and combinations thereof. Most preferably, $R^{6k}$ is phenyl.

$R^{7k}$ is preferably

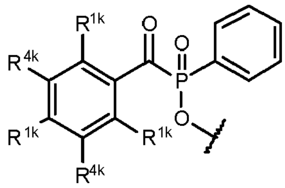

,

most preferably

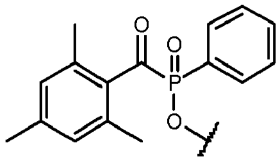

.

In some embodiments, no $R^{7k}$ is present, meaning that the structure according to Formula (III) has a single monoacylphosphine oxide moiety.

In such embodiments, it is preferred that $R^{5k}$ is selected from the groups consisting of hydrogen, $C_1$-$C_{20}$ alkyl, $-(CH_2CH_2O-)_nCH_3$, and $-(CH_2CH_2O-)_nH$, wherein n is an integer in the range from 1 to 20. It is particularly preferred that $R^{5k}$ is $C_1$-$C_{20}$ alkyl, more preferably $C_1$-$C_6$ alkyl. Most preferably, $R^{5k}$ is ethyl.

In other embodiments, at least one instance of $R^{7k}$ is present, meaning that the structure according to Formula (XVII) has more than one monoacylphosphine oxide moiety.

Such embodiments are preferably described by Formula (XVII) wherein $R^{5k}$ has a structure according to formula (XVIII):

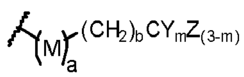

(XVIII)

wherein each instance of M is independently selected from ($CH_2CH_2O$) and ($CH_2CH(CH_3)O$);
wherein each instance of Y is independently selected from hydrogen and $C_1$-$C_4$ alkyl;
wherein each instance of Z has the structure $CH_2(M^1)_cR^{7k}$;
wherein each instance of $M^1$ is independently selected from ($OCH_2CH_2$) and ($OCH(CH_3)CH_2$)
wherein a is an integer in the range from 0 to 15;
wherein b is an integer in the range from 0 to 6;
wherein each instance of c is independently an integer in the range from 0 to 15; and
wherein m is an integer in the range from 0 to 2.

Such structures are typically formed by combining a central polyol core with multiple monoacylphosphinate residues, wherein ethylene glycol/propylene glycol spacers (i.e. units M and $M^1$) are optionally used to separate the central polyol core from the monoacylphosphinate residues.

Suitable polyol cores include glycerol, wherein b= 0, m = 1 and Y =H, trimethylolpropane, wherein b = 1, m = 1 and Y = ethyl, pentaerythritol, wherein b =1, m = 0, neopentyl glycol, wherein b= 1 m =2 and both instances of Y = methyl, ethylene glycol, wherein b = 0, m = 2, and both instances of Y = H; 1,6-hexanediol, wherein b = 4, m = 2 and both instances of Y = H.

Other suitable polyols include propylene glycol, 1,2-butanediol, 1,3-butanediol, 1,4-butanediol, 2,3-butanediol, 1,2-hexanediol, 1,5-hexanediol, 2,5-hexanediol. The skilled person would be aware of which values of b and m as well as choice of Y correspond to these polyols.

Particularly preferred polyol cores are glycerol, wherein b= 0, m = 1 and Y =H, trimethylolpropane, wherein b = 1, m = 1 and Y = ethyl, pentaerythritol, wherein b =1, m = 0.

When a gylcerol core is used, $R^{5k}$ is termed "optionally ethoxylated/propoxylated glycerol".

When a trimethylolpropane core is used, $R^{5k}$ is termed "optionally ethoxylated/propoxylated trimethylolpropane".

When a pentaerythritol core is used, $R^{5k}$ is termed "optionally ethoxylated/propoxylated pentaerythritol".

When a neopentyl glycol core is used, $R^{5k}$ is termed "optionally ethoxylated/propoxylated neopentyl glycol".

When an ethylene glycol core is used, $R^{5k}$ is termed "optionally ethoxylated/propoxylated ethylene glycol".

When a 1,6-hexanediol core is used, $R^{5k}$ is termed "optionally ethoxylated/propoxylated 1,6-hexanediol".

It is particularly preferred that a is an integer in the range from 1 to 15 and each instance of c is an integer in the range from 1 to 15, wherein the sum of a and each instance of c is in the range from 3 to 20, more preferably in the range from 3 to 15, most preferably in the range from 3 to 10.

Such embodiments are termed "ethoxylated/propoxylated polyol", wherein polyol may be glycerol, trimethylolpropane, pentaerythritol, neopentyl glycol, ethylene glycol or 1,6-hexanediol.

It is particularly preferred that $R^{5k}$ is selected from the group consisting of $C_1$-$C_6$ alkyl, ethoxylated/propoxylated glycerol, ethoxylated/propoxylated trimethylolpropane, and ethoxylated/propoxylated pentaerythritol.

Examples of particularly preferred monoacylphosphine oxide photoinitiators having a structure according to formula (XVII) include:

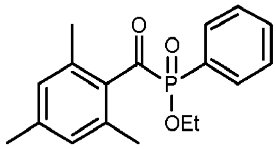
,
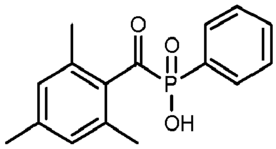
,
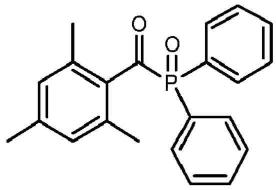
,
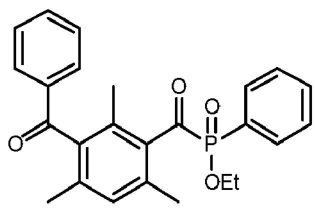
,

and

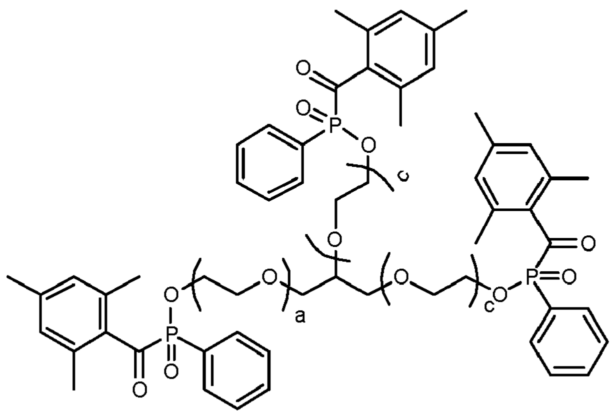

,

wherein each instance of a and each instance of c are independently as defined for formula (XVIII).

It is particularly preferred that the monoacylphosphine oxide according to formula (XVII) has a formula according to formula (XVIIa), more preferably according to formula (XVIIb), most preferably according to formula (XVIIc):

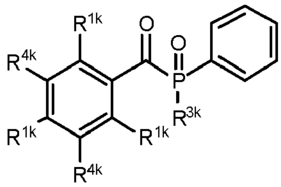

(XVIIa)

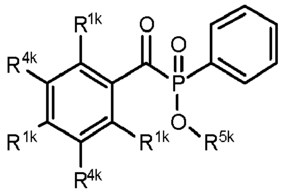

(XVIIb)

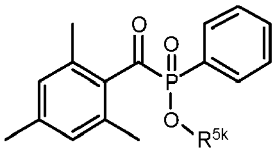

(XVIIc)

wherein $R^{1k}$, $R^{3k}$, $R^{4k}$ and $R^{5k}$ are as defined for formula (XVII).

Suitable monoacylphosphine oxide photoinitiators include photoinitiators include, for example, 2,4,6-trimethylbenzoyl-diphenyl phosphine oxide and ethyl (2,4,6-trimethylbenzoyl) phenylphosphinate, Phenyl(2,4,6-trimethylbenzoyl) phosphinic acid, glSycerol ethoxylated trimester (Omnipol® TP from IGM Resins B.V.) or those described in US2017/0240659 and Speedcure XKM (from Lambson).

It is, however, preferred that at least one of the one or more photoinitiators (PI) is a bisacylphosphine oxide photoinitiator.

In the broadest sense, any bisacylphosphine oxide photoinitiator may be used; however, it is preferred that at least one, preferably all, of the one or more bisacylphosphine oxide photoinitiators has a structure according to any one of formulae (III) to (VI).

Formula (III):

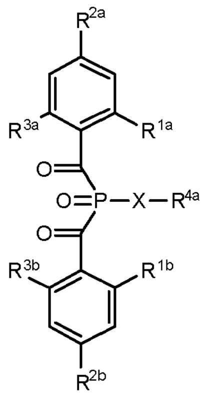

(III)

wherein each instance of $R^{1a}$, $R^{2a}$, $R^{3a}$, $R^{1b}$, $R^{2b}$ and $R^{3b}$ is independently selected from the group consisting of $C_1$-$C_4$ alkyl, $C_1$-$C_4$ alkoxy or halogen;
wherein X is selected from the group consisting of direct single bond, O, S, $NR^{5a}$, $-CH_2CO_2-$, and $-CH_2CH_2CO_2-$;
wherein $R^{4a}$ is selected from the group consisting of hydrogen, $(CO)R^{6a}$, $(CO)OR^{6a}$, $(CO)NR^{5a}R^{6a}$, $(SO_2)R^{6a}$, $[Si(R^{7a})(R^{8a})]_m$-$Si(R^{7a})(R^{8a})(R^{9a})$, $[Si(R^{7a})(R^{8a})O]_m$-$Si(R^{7a})(R^{8a})(R^{9a})$; or
wherein $R^{4a}$ is $C_1$-$C_{28}$ alkyl or $C_2$-$C_{28}$ alkyl which is interrupted by one or more O, $NR^{5a}$, S, (CO), (CO)O, or $SO_2$, wherein said $C_1$- $C_{28}$ alkyl or interrupted $C_2$-$C_{28}$ alkyl is unsubstituted or substituted by one or more substituents selected from the group consisting of OH, $C_6$-$C_{14}$ aryl, $[Si(R^{7a})(R^{8a})]_m$-$Si(R^{7a})(R^{8a})(R^{9a})$, $[Si(R^{7a})(R^{8a})$-$O]_m$-$Si(R^{7a})(R^{8a})(R^{9a})$, $N(R^{5a})_2$, 2-oxiranyl, $C_3$-$C_{12}$ cycloalkyl which is unsubstituted or substituted by $C_1$-$C_4$ alkyl, $C_1$-$C_4$ alkoxy or by OH, $C_3$-$C_{12}$ cycloalkyl which is interrupted by one or more O, $NR^{5a}$ or S and which interrupted $C_3$-$C_{12}$ cycloalkyl is unsubstituted or substituted by $C_1$-$C_4$ alkyl, $C_1$-$C_4$ alkoxy or by OH, and $C_6$-$C_{14}$ aryl which is unsubstituted or substituted by $C_1$-$C_4$alkyl, $C_1$-$C_4$ alkoxy or by OH; or
wherein $R^{4a}$ is $C_6$-$C_{10}$ aryl which is unsubstituted or substituted by one or more $C_1$- $C_{12}$ alkyl, $C_2$-$C_{20}$ alkyl which is interrupted by one or more O, $C_1$-$C_{12}$-alkoxy or by OH; or
wherein, in cases where X is $NR^{5a}$, $R^{4a}$ together with $R^{5a}$ and the N-atom forms a 5 or 6-membered saturated ring which is uninterrupted or interrupted by O or $NR^{5a}$ and which uninterrupted or interrupted ring is unsubstituted or substituted by one or more $C_1$-$C_4$alkyl, $C_1$-$C_4$ alkoxy or by OH; or
wherein $R^{4a}$ is selected from the group consisting of structures (A) to (G):

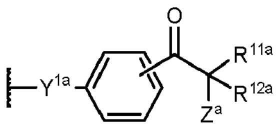

(A)

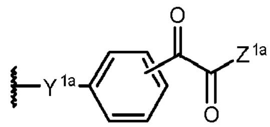

(B)

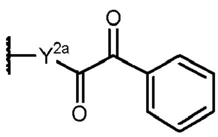

(C)

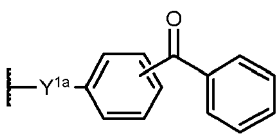

(D)

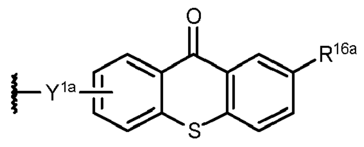

(E)

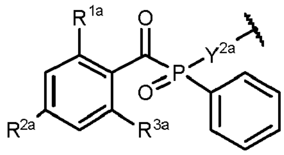

(F)

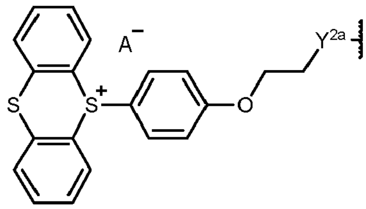

(G)

wherein all options for $R^{4a}$ may be further substituted by one or more groups, selected from OH and $R^{17a}$; wherein $R^{17a}$ is

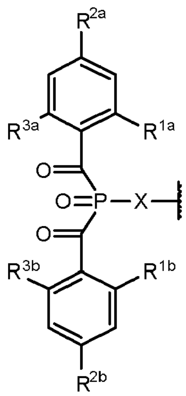

;

wherein A is $PF_6$, $SbF_6$, $AsF_6$ or $B(C_6F_5)_4$;
wherein $R^{5a}$ is hydrogen, $(CO)R^{6a}$, phenyl, $C_1$-$C_{12}$ alkyl, $C_2$-$C_{12}$ alkyl which is interrupted by one or more O, wherein said $C_1$-$C_{12}$ alkyl or interrupted $C_2$-$C_{12}$ alkyl is unsubstituted or substituted by one or more $C_3$-$C_7$ cycloalkyl, OH or by NCO, $C_3$-$C_{12}$ cycloalkyl which is unsubstituted or substituted by one or more $C_1$-$C_4$ alkyl, $C_1$-$C_4$ alkoxy, OH or by NCO;
wherein $R^{6a}$ is $C_1$-$C_{12}$ alkyl or $C_2$-$C_{12}$alkyl which is interrupted by one or more O, wherein said $C_1$-$C_{12}$ alkyl or interrupted $C_2$-$C_{12}$ alkyl is unsubstituted or substituted by one or more $C_3$-$C_7$ cycloalkyl, OH, NCO or by phenyl which is substituted by NCO; or
wherein $R^{6a}$ is $C_3$-$C_{12}$ cycloalkyl or $C_2$-$C_{10}$ alkenyl which is unsubstituted or substituted by one or more $C_1$-$C_4$ alkyl, OH or $C_1$-$C_4$ alkoxy; or
wherein $R^{6a}$ is $C_6$-$C_{14}$ aryl which is unsubstituted or substituted by $C_1$-$C_{12}$ alkyl, $C_1$-$C_{12}$ alkoxy, NCO or by NCO-substituted $C_1$-$C_{12}$ alkyl; or
wherein if the group $N(R^{5a})_2$ is present, then one instance of $R^{5a}$ may be $(CO)R^{6a}$, wherein the other instance of $R^{5a}$ and $R^{6a}$, together with the N and CO moieties form a 5- or 6-mebered ring, which is either uninterrupted or interrupted by O or $NR^{5a}$ and which uninterrupted or interrupted ring is either unsubstituted or substituted by one or more $C_1$-$C_4$ alkyl, $C_1$-$C_4$ alkoxy, or by OH;
wherein $R^{7a}$, $R^{8a}$, and $R^{9a}$ are each independently selected from the group consisting of $C_1$-$C_4$ alkyl, $C_6$-$C_{14}$ aryl or $C_1$-$C_4$ alkoxy;
wherein m is an integer in the range from 0-10;
wherein $Y^{1a}$ is selected from the group consisting of a direct single bond, O, S, $NR^{5a}$ , O(CO)-* or $O(CO)CH_2O$-*, wherein the asterix denotes the bond to the phenyl ring of the group (A), (B), (D), or (E);
wherein $Y^{2a}$ is selected from the group consisting of a direct single bond, O, S or $NR^{5a}$;

wherein $R^{11a}$ and $R^{12a}$ independently of each other are $C_1$-$C_{10}$alkyl, $C_2$-$C_{10}$ alkenyl or phenyl, $C_1$-$C_4$ alkyl which is unsubstituted or substituted by $C_1$-$C_4$ alkyl, or $R^{11a}$ and $R^{12a}$ together with the C-atom to which they are attached form a cyclohexane or cyclopentane ring;
wherein $Z^a$ is OH or $NR^{13a}R^{14a}$ ;
wherein $Z^{1a}$ is $C_1$-$C_{12}$ alkoxy or $C_2$-$C_{12}$ alkoxy which is interrupted by one or more O, wherein said $C_1$-$C_{12}$ alkoxy or interrupted $C_2$-$C_{12}$ alkoxy is unsubstituted or substituted by OH;
wherein $R^{13a}$ and $R^{14a}$ independently of each other are $C_1$-$C_{12}$ alkyl, $C_1$-$C_{12}$ alkyl which is substituted by one or more OH or halogen; or
wherein $R^{13a}$ and $R^{14a}$ together with the N- atom to which they are attached form a 5- or 6-membered unsaturated or saturated ring, which ring is uninterrupted or interrupted by O or $NR^{15a,}$ wherein $R^{15a}$ is $C_1$-$C_4$ alkyl;
wherein $R^{16a}$ is hydrogen or $C_1$-$C_4$ alkyl; provided that

(i) if $R^{1a}$, $R^{2a}$ and $R^{3a}$ as $C_1$-$C_4$ alkyl are methyl and X is O, then $R^4$ as $C_1$-$C_{28}$ alkyl is not methyl, ethyl, n-propyl, 2-propyl, n-butyl, sec-butyl, tert-butyl, n-hexyl;
(ii) if $R^{1a}$ and $R^{3a}$ as halogen are Cl, $R^{2a}$ is hydrogen and X is O, then $R^{4a}$ as substituted $C_3$-$C_{10}$ aryl is not 4-butyl-phenyl; and
(iii) if $R^{1a}$ and $R^{3a}$ as $C_1$-$C_4$ alkoxy are methoxy, $R^{2a}$ is hydrogen and X is $NR^{5a}$, and $R^{4a}$ together with $R^{5a}$ and the N-atom forms a 5 or 6-membered saturated ring, then said ring is not a piperidine ring.

Formula (IV):

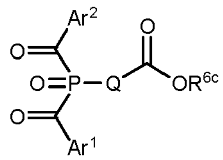

(IV)

wherein $Ar^1$ and $Ar^2$ are each independently

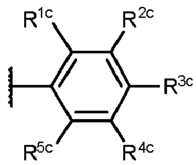

or naphthyl which is unsubstituted or substituted one or more times by $R^{1c}$, $R^{2c}$, $R^{3c}$, $R^{4c}$, or $R^{5c}$;
wherein $R^{1c}$ and $R^{5c}$ are each independently selected from the group consisting of $C_1$-$C_4$ alkyl, $C_1$-$C_4$ alkoxy or halogen;
wherein $R^{3c}$ is selected from the group consisting of hydrogen, $C_1$-$C_4$ alkyl, halogen, $C_1$-$C_4$ alkoxy or $C_2$-$C_{20}$ alkoxy which is interrupted by one or more O;
wherein Q is $C_1$-$C_4$ alkylene;
wherein $R^{2c}$ and $R^{4c}$ independently of each other are hydrogen or $PG^c$-$Y^c$-$Z^c$-$X^c$-;
wherein $PG^c$ is a polymerizable group or methyl or ethyl;
wherein $Y^c$ is a direct single bond, O or S;
wherein $X^c$ is a direct single bond, O or S;
wherein $Z^c$ is a direct single bond, $C_1$-$C_{20}$ alkylene or $C_2$-$C_{20}$ alkylene which is interrupted by one or more O;
wherein $R^{6c}$ is $C_3$-$C_{30}$ alkyl which is unsubstituted or substituted by one or more of the groups selected from OH and

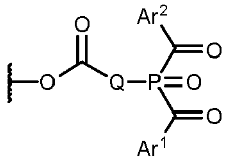

;

or
wherein $R^{6c}$ is $C_3$-$C_{28}$ alkyl which is interrupted by one or more O or $C_3$-$C_8$ cycloalkylene and which interrupted $C_3$-$C_{28}$ alkyl is unsubstituted or substituted by one or more of the groups selected from OH and

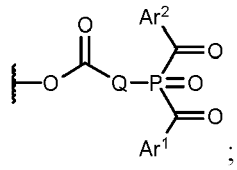
;

Formula (V):

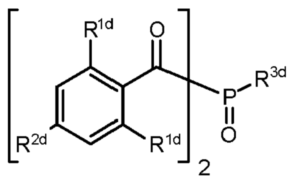
(V)

wherein $R^{1d}$ is $C_1$-$C_4$ alkyl, $C_1$-$C_4$ alkoxy or halogen;
wherein $R^{2d}$ is hydrogen, $C_1$-$C_4$ alkyl, $C_1$-$C_4$ alkoxy or halogen; and
wherein $R^{3d}$ is $C_1$-$C_{20}$ alkyl, cyclopentyl, cyclohexyl, phenyl-$C_1$-$C_4$ alkyl, naphthyl, biphenylyl or an O-, S- or N-containing 5- or 6-membered heterocyclic ring, the naphthyl, biphenylyl and O-, S- or N-containing 5- or 6- membered heterocyclic ring radicals being unsubstituted or substituted by $C_1$-$C_4$ alkyl, $C_1$-$C_4$ alkoxy, halogen, $C_1$-$C_4$ alkylthio; or wherein $R^{3d}$ is

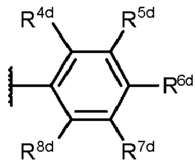

wherein $R^{4d}$, $R^{5d}$, $R^{6d}$, $R^{7d}$ and $R^{8d}$ are each independently selected from the group consisting of hydrogen, halogen, $C_1$-$C_{20}$ alkyl, cyclopentyl, cyclohexyl, $C_2$-$C_{12}$ alkenyl, $C_2$-$C_{20}$ alkyl interrupted by one or more non-consecutive O atoms, phenyl-$C_1$-$C_4$ alkyl, $C_1$-$C_{20}$ alkoxy, or phenyl that is unsubstituted or substituted by one or two $C_1$-$C_4$ alkyl or/and $C_1$-$C_4$ alkoxy substituents.

Formula (VI):

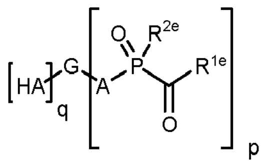
(VI)

wherein each A represents independently of one another O, S, $NR^{3e}$;
wherein G is a residue of the multifunctional compound (core) G-$(A\text{-}H)_{p+q}$, wherein each A-H represents an alcoholic or amino or thiol group;
wherein p and q are both integer numbers, p+q is an integer in the range from 3 to 10, and p is an integer in the range from 3 to 8;
wherein $R^{1e}$ and $R^{2e}$ are each independently selected from the group consisting of $C_1$-$C_{18}$ alkyl, $C_6$-$C_{12}$ aryl and $C_5$-$C_{12}$ cycloalkyl, each of which is uninterrupted or interrupted by one or more oxygen and/or sulfur atoms and/or one or more substituted or unsubstituted amino groups, or are a five- to six-membered heterocyclyl containing oxygen and/or nitrogen and/or sulfur atoms; where each of said groups may be substituted by aryl, alkyl, aryloxy, alkoxy, heteroatoms and/or heterocyclic radicals; $R^{2e}$ may also be $(CO)R^{1e}$;
wherein $R3^e$ is hydrogen or $C_1$-$C_4$ alkyl.

In one embodiment, at least one of the one or more photoinitiators (PI) each have a structure according to formula (VII):

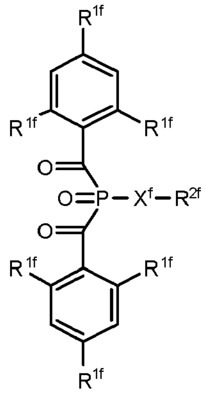

(VII)

wherein each instance of $R^{1f}$ is independently selected from the group consisting of $C_1$-$C_4$ alkyl;
wherein $X^f$ is selected from the group consisting of direct single bond, O, S, $NR^{4f}$,$-CH_2CO_2-$, and $-CH_2CH_2CO_2-$;
wherein $R^{2f}$ is selected from the group consisting of $C_1$-$C_{40}$ alkyl and interrupted $C_2$-$C_{40}$ alkyl being interrupted by one or more O or $C_3$-$C_8$ cycloalkylene, wherein said $C_1$-$C_{40}$ alkyl or interrupted $C_2$-$C_{40}$ alkyl may be unsubstituted or substituted by one or more groups selected from OH and $R^{3f}$;
wherein $R^{3f}$ is

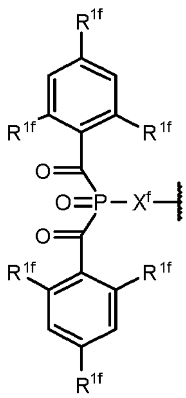

;

wherein $R^{4f}$ is selected from the group consisting of hydrogen, $(CO)R^{5f}$, phenyl, $C_1$-$C_{12}$ alkyl, $C_2$-$C_{12}$ alkyl being interrupted by one or more O, wherein said $C_1$-$C_{12}$ alkyl or interrupted $C_2$-$C_{12}$ alkyl is unsubstituted or substituted by one or more $C_3$-$C_7$ cycloalkyl, OH or by NCO, $C_3$-$C_{12}$ cycloalkyl which is unsubstituted or substituted by one or more $C_1$-$C_4$ alkyl, $C_1$-$C_4$ alkoxy, OH or by NCO; and
wherein $R^{5f}$ is selected from the group consisting of $C_1$-$C_{12}$ alkyl or $C_2$-$C_{12}$ alkyl which is interrupted by one or more O, wherein said $C_1$-$C_{12}$ alkyl or interrupted $C_2$-$C_{12}$ alkyl is unsubstituted or substituted by one or more $C_3$-$C_7$-cycloalkyl, OH, NCO or by phenyl which is substituted by NCO; $C_3$-$C_{12}$ cycloalkyl; $C_2$-$C_{10}$ alkenyl which is unsubstituted or substituted by one or more $C_1$-$C_4$ alkyl, OH or $C_1$-$C_4$ alkoxy; $C_6$-$C_{14}$ aryl which is unsubstituted or substituted by $C_1$-$C_{12}$ alkyl, $C_1$-$C_{12}$ alkoxy, NCO or by NCO-substituted $C_1$-$C_{12}$ alkyl.

Each instance of $R^{1f}$ may be independently selected from the group consisting of $C_1$-$C_4$ alkyl, i.e. from methyl, ethyl, n-propyl, i-propyl, n-butyl, s-butyl, i-butyl and t-butyl. It is particularly preferred that each instance of $R^{1f}$ is selected from methyl and ethyl. Most preferably, each instance of $R^{1f}$ is methyl.

$X^f$ is selected from the group consisting of direct single bond, O, S, $NR^{3f}$, $-CH_2CO_2-$, and $-CH_2CH_2CO_2-$. More preferably, $X^f$ is selected from the group consisting of direct single bond, O, - $CH_2CO_2-$, and $-CH_2CH_2CO_2-$. Yet more preferably, $X^f$ is selected from the group consisting of direct single bond $-CH_2CO_2-$, and $-CH_2CH_2CO_2-$. Most preferably $X^f$ is a direct single bond.

$R^{1f}$ is selected from the group consisting of $C_1$-$C_{40}$ alkyl and interrupted $C_2$-$C_{40}$ alkyl being interrupted by one or more O or $C_3$-$C_8$ cycloalkylene, wherein said $C_1$-$C_{40}$ alkyl or interrupted $C_2$-$C_{40}$ alkyl may be unsubstituted or substituted by one or more groups selected from OH and $R^{3f}$;
wherein $R^{3f}$ is

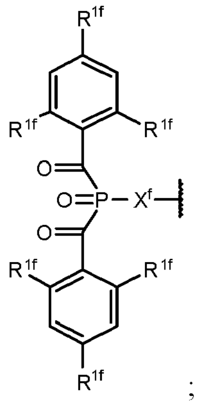

;

In some embodiments no $R^{3f}$ is present, meaning that the structure according to Formula (VI) has a single bisacylphosphine oxide moiety.

In such embodiments, it is preferred that $R^{2f}$ is selected from the group consisting of $C_1$-$C_{20}$ alkyl, $-(CH_2CH_2O-)_nCH_3$, and $-(CH_2CH_2O-)_nH$, wherein n is an integer in the range from 1 to 20. It is particularly preferred that $R^{2f}$ is $C_1$-$C_{20}$ alkyl.

Especially preferred are embodiments wherein $X^f$ is single direct bond and $R^{2f}$ is $C_1$-$C_{20}$ alkyl. It is particularly preferred in such embodiments that each instance of $R^{1f}$ is methyl.

Similarly, embodiments wherein $X^f$ is O and $R^{2f}$ is $-(CH_2CH_2O-)_nCH_3$ or $-(CH_2CH_2O-)_nH$ are also especially preferred. It is particularly preferred in such embodiments that each instance of $R^{1f}$ is methyl.

In other embodiments, at least one instance of $R^{3f}$ is present, meaning that the structure according to Formula (VI) has more than one bisacylphosphine oxide moiety.

Such embodiments are preferably described by Formula (VII) wherein $R^{1f}$ has a structure according to formula (VIII):

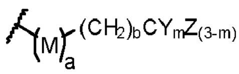

(VIII)

wherein each instance of M is independently selected from $(CH_2CH_2O)$ and $(CH_2CH(CH_3)O)$;
wherein each instance of Y is independently selected from hydrogen and $C_1$-$C_4$ alkyl;
wherein each instance of Z has the structure $CH_2(M^1)_cR^{2f}$;
wherein each instance of $M^1$ is independently selected from $(OCH_2CH_2)$ and $(OCH(CH_3)CH_2)$
wherein a is an integer in the range from 0 to 15;
wherein b is an integer in the range from 0 to 6;
wherein each instance of c is independently an integer in the range from 0 to 15;
wherein m is an integer in the range from 0 to 2; and
wherein each instance of $X^f$ is independently selected from the group consisting of $-CH_2CO_2-$, and $-CH_2CH_2CO_2-$.

Such structures are typically formed by combining a central polyol core with multiple BAPO-based carboxylic acid residues, wherein ethylene glycol/propylene glycol spacers (i.e. units M and $M^1$) are optionally used to separate the central polyol core from the BAPO-based carboxylic acid residues.

Suitable polyol cores include glycerol, wherein b= 0, m = 1 and Y =H, trimethylolpropane, wherein b = 1, m = 1 and Y = ethyl, pentaerythritol, wherein b =1, m = 0, neopentyl glycol, wherein b= 1 m =2 and both instances of Y = methyl, ethylene glycol, wherein b = 0, m = 2, and both instances of Y = H; 1,6-hexanediol, wherein b = 4, m = 2 and both instances of Y = H.

Other suitable polyols include propylene glycol, 1,2-butanediol, 1,3-butanediol, 1,4-butanediol, 2,3-butanediol, 1,2-hexanediol, 1,5-hexanediol, 2,5-hexanediol. The skilled person would be aware of which values of b and m as well as choice of Y correspond to these polyols.

Particularly preferred polyol cores are glycerol, wherein b= 0, m = 1 and Y =H, trimethylolpropane, wherein b = 1, m = 1 and Y = ethyl, pentaerythritol, wherein b =1, m = 0.

When a gylcerol core is used, $R^{2f}$ is termed "optionally ethoxylated/propoxylated glycerol".

When a trimethylolpropane core is used, $R^{2f}$ is termed "optionally ethoxylated/propoxylated trimethylolpropane".

When a pentaerythritol core is used, $R^{2f}$ is termed "optionally ethoxylated/propoxylated pentaerythritol".

When a neopentyl glycol core is used, $R^{2f}$ is termed "optionally ethoxylated/propoxylated neopentyl glycol".

When an ethylene glycol core is used, $R^{2f}$ is termed "optionally ethoxylated/propoxylated ethylene glycol".

When a 1,6-hexanediol core is used, $R^{2f}$ is termed "optionally ethoxylated/propoxylated 1,6-hexanediol".

It is particularly preferred that a is an integer in the range from 1 to 15 and each instance of c is an integer in the range from 1 to 15, wherein the sum of a and each instance of c is in the range from 3 to 20, more preferably in the range from 3 to 15, most preferably in the range from 3 to 10.

Such embodiments are termed "ethoxylated/propoxylated polyol", wherein polyol may be glycerol, trimethylolpropane, pentaerythritol, neopentyl glycol, ethylene glycol or 1,6-hexanediol.

It is particularly preferred that $R^{2f}$ is selected from the group consisting of $C_1$-$C_{20}$ alkyl, $-(CH_2CH_2O-)_nCH_3$, and $-(CH_2CH_2O-)_nH$, wherein n is an integer in the range from 1 to 20, ethoxylated/propoxylated glycerol, ethoxylated/propoxylated trimethylolpropane, and ethoxylated/propoxylated pentaerythritol.

When $R^{2f}$ is a $C_1$-$C_{20}$ alkyl, it is particularly preferred that $R^{2f}$ is a $C_1$-$C_{15}$ alkyl, more preferably a $C_1$-$C_{12}$ alkyl.

It is particularly preferred that each of the one or more bisacylphosphine oxide photoinitiators each have a structure according to formula (VI)

In alternative embodiment, at least one of the one or more bisacylphosphine oxide photoinitiators each have a structure according to formula (VI), wherein each instance of $R^{1f}$ is independently selected from the group consisting of $C_1$-$C_4$ alkyl, $X^f$ is a direct single bond and $R^{2f}$ is selected from the group consisting of $C_6$-$C_{14}$ aryl, $C_1$-$C_{20}$ alkyl, $-(CH_2CH_2O-)_nCH_3$, and $-(CH_2CH_2O-)_nH$, wherein n is an integer in the range from 1 to 20.

More preferably, $R^{2f}$ is selected from $C_6$-$C_{14}$ aryl, most preferably is phenyl.

In one particularly preferred embodiment, each instance of $R^{1f}$ is methyl, $X^f$ is a direct single bond and $R^{2f}$ is phenyl.

In addition to the photoinitiators having a structure according to formulae (III) to (VII), additional photoinitiators, preferably additional Norrish Type-I photoinitiators or cationic photoinitiators may be employed.

Examples of other suitable photoinitiators are camphorquinone, benzophenone, benzophenone derivatives, acetophenone, acetophenone derivatives, dialkoxyacetophenones, $\alpha$-hydroxyketones, $\alpha$-aminoketones, 4-aroyl-1,3-dioxolanes, benzoin alkyl ethers and benzil ketals, e.g. benzil dimethyl ketal, ketosulfones, e.g 1-[4-[(4-benzoyl-phenyl)-thio]-phenyl]-2-methyl-2-[(4-methyl-phenyl)-sulfonyl]-propan-1-one (Esacure® 1001, from IGM Resins B.V.), 3-ketocoumarins, for example as described in EP2909243 and WO2017216699, phenylglyoxylates and derivatives thereof, dimeric phenyl glyoxylates, peresters, e.g. benzophenonetetracarboxylic acid peresters, for example as described in EP 126 541, acylphosphine photoinitiators (which can be chosen among monoacylphosphine oxides, bis-acylphosphine oxides, tris-acylphosphine oxides and multifunctional mono- or bisacylphosphine oxides), halomethyltriazines, hexaaryl bisimidazole/coinitiator systems, e.g. ortho-chlorohexaphenylbisimidazole in combination with 2-mercaptobenzothiazole, ferrocenium compounds or titanocenes, for example dicyclopentadienyl-bis(2,6-difluoro-3-pyrrolo-phenyl)titanium, O-acyloxime ester photoinitiators.

Examples of $\alpha$-hydroxyketones and $\alpha$-aminoketones are 1-hydroxy cyclohexylphenyl ketone, 2-hydroxy-2-methyl-1-phenyl-propane-1-one, 1-[4-(2-hydroxyethoxy)phenyl]-2-hydroxy-2-methyl-1-propane-1-one, 2-hydroxy-1-{4-[4-(2-hydroxy-2-methyl-propionyl)-benzyl]phenyl}-2-ethyl-propane-1-one), 2-hydroxy-1-{4-[4-(2-hydroxy-2-methyl-propionyl)-phenoxy]-phenyl}-2-methyl-propan-1-one, 2-methyl-1-(4-methylthiophenyl)-2-morpholinopropane-1-one), 2-benzyl-2-dimethylamino-1-(4-morpholinophenyl)-butane-1-one, and (2-(dimethylamino)-2-[(4-methylphenyl) methyl]-1-[4-(4-morpholinyl) phenyl]-1-butanone).

Examples of O-acyloxime ester photoinitiators are 1,2-octanedione,1-[4-(phenylthio)phenyl]-2-(O-benzoyloxime), ethanone 1-[9-ethyl-6-(2-methylbenzoyl)-9H-carbazole-3-yl] 1-(O-acetyloxime) or those described in GB 2339571.

Examples of acylphosphine photoinitiators include, but are not limited to, bis(2,4,6-trimethylbenzoyl)phenylphosphine oxide, bis(2,6-dimethoxybenzoyl)-2,4,4-trimethylpentyl phosphine oxide, bis(2,4,6-trimethylbenzoyl)-(2,4-dipentyloxyphenyl), 2,4,6-trimethylbenzoyl-diphenyl phosphine oxide and ethyl (2,4,6-trimethylbenzoyl) phenylphosphinate, Phenyl(2,4,6-trimethylbenzoyl)phosphinic acid, glycerol ethoxylated trimester (Omnipol® TP from IGM Resins B.V.).

Examples of the halomethyltriazines based photoinitiators are 2-[2-(4-methoxy-phenyl)-vinyl]-4,6-bistrichloromethyl [1,3,5]triazine, 2-(4-methoxy-phenyl)-4,6-bis-trichloromethyl [1,3,5]triazine, 2-(3,4-dimethoxyphenyl)-4,6-bis-trichloromethyl [1,3,5]triazine, 2-methyl-4,6-bis-trichloromethyl [1,3,5] triazine.

Cationic photoinitiators can be also used as the photoinitiators, either alone or in combination with Norrish Type I and/or Norrish Type II photoinitiators. Examples of suitable cationic photoinitiators are aromatic sulfonium, phosphonium or iodonium salts, as described e.g. in US 4,950,581, or cyclopentadienylarene-iron(II) complex salts, e.g. ($\eta^6$-isopropylbenzene)($\eta^5$-cyclopentadienyl) iron(II) hexafluorophosphate or photolatent acids based on oximes, as described, for example, in GB 2 348 644, US4,450,598, US4,136,055, WO 00/10972 and WO 00/26219.

Additionally/alternatively, Norrish Type-II photoinitiators can be also used. Examples of suitable Norrish Type-II photoinitiators include, aromatic carbonyl compounds, e.g. benzophenones, thioxanthones, anthraquinones, and 3-acylcoumarin derivatives, terphenyls, styryl ketones, and 3-(aroylmethylene)-thiazolines, camphorquinones and also eosin, rhodamine and erythrosine dyes. Examples of each of these compound classes are given in the following section describing the one or more further photosensitizers having a structure other than formula (I).

The one or more photoinitiators (PI) are preferably present in a total amount in the range from 0.5 to 25.0 wt.-%, more preferably in the range from 0.8 to 20.0 wt.-%, most preferably in the range from 1.0 to 15.0 wt.-%, relative to the total weight of the photopolymerizable composition (PC).

**The one or more photosensitizers (S) having a structure according to formula (I)**

Another of the essential components of the photopolymerizable composition (PC) according to the present invention is one or more photosensitizers (S) having a structure according to formula (I).

Each of the one or more photosensitizers (S) has a structure according to formula (I):

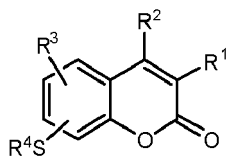 (I)

wherein $R^1$ and $R^2$ are independently selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,

wherein $R^3$ represents from 0 to 3 substitutions, each being selected from the group consisting of hydrogen, halogen, $C_1$-$C_{10}$ alkyl, $C_6$-$C_{14}$ aryl, $OR^5$, $SR^5$, and $NR^5_2$, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,

wherein $R^4$ is selected from the group consisting of $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl, and

wherein at least one of $R^1$ and $R^2$ is not hydrogen,

wherein each instance of $R^1$ to $R^5$ may optionally be joined to one or more further instances of $R^1$ to $R^5$ to form one or more 5-membered or 6-membered rings.

In a preferred embodiment, at least one of the photosensitizers according least one of the one or more photosensitizers (S), preferably each of the one or more photosensitizers (S), has a structure according to formula (II):

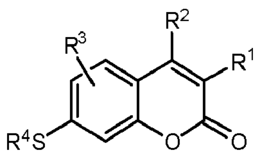 (II)

wherein $R^1$, $R^2$, $R^3$, and $R^4$ are each as defined for formula (I).

For both Formula (I) and (II), it is preferred that $R^1$ is selected from the group consisting of hydrogen and $C_6$-$C_{14}$ aryl, wherein the $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl.

More preferably, $R^1$ is phenyl, wherein the phenyl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl.

Most preferably, $R^1$ is unsubstituted phenyl.

Alternatively, $R^1$ is 4-ethylmercaptophenyl.

For both Formula (I) and (II), it is preferred that $R^2$ is selected from the group consisting of hydrogen and unsubstituted $C_1$-$C_{10}$ alkyl.

More preferably, $R^2$ is hydrogen.

In another embodiment, $R^2$ may be methyl.

For both Formula (I) and (II), it is preferred that $R^3$ represents no substitutions.

For both Formula (I) and (II), it is preferred that $R^4$ is $C_1$-$C_{10}$ alkyl, wherein the $C_1$-$C_{10}$ alkyl may be unsubstituted or substituted by one or more substituents selected from the group consisting of $OR^5$, $SR^5$, and $NR^5_2$, wherein each instance of $R^5$ is independently selected from the group consisting of hydrogen, and $C_1$-$C_{10}$ alkyl.

More preferably, $R^4$ is unsubstituted $C_1$-$C_{10}$ alkyl.

Particularly preferred instances of $R^4$ include ethyl, 2-hydroxyethyl, 2-(dimethylamino)ethyl, and 2-ethylhexyl.

It is particularly preferred that at least one, preferably all, of the photosensitizers (S) having a structure according to formula (I) is/are selected from the group consisting of:

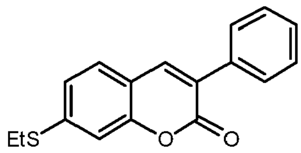,
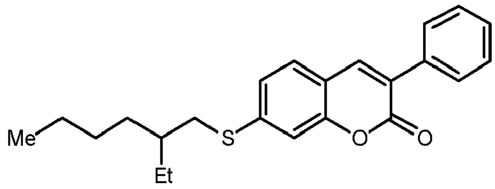,

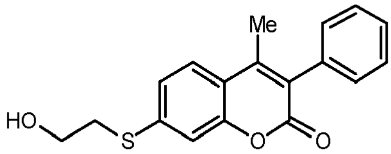,
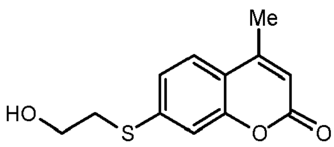,
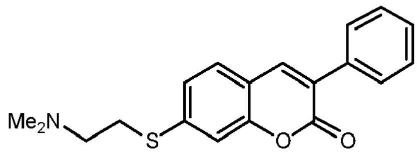,

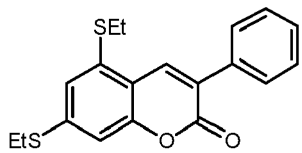, and
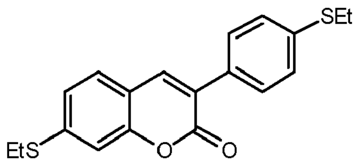.

It is preferred that at least one, preferably all, of the photosensitizers (S) having a structure according to formula (I) have a maximum absorption peak wavelength ($\lambda^{abs}$ max) in the range from 325 to 360 nm, more preferably in the range from 328 to 357 nm, most preferably in the range from 330 to 355 nm, determined according to the method given in the determination methods.

It is also preferred that at least one, preferably all, of the photosensitizers (S) having a structure according to formula (I) have a maximum fluorescent emission peak wavelength in the range from 350 to 470 nm, more preferably in the range from 370 to 455 nm, most preferably in the range from 390 to 445 nm, determined according to the method given in the determination methods.

It is preferred that at least one, preferably all, of the photosensitizers having a structure according to formula (I) fulfils the following inequation:

$$\lambda^{fluo}\,\max \leq 450 - n(345 - \lambda^{abs}\max)^2$$

wherein n is 0.10, preferably n is 0.15, most preferably n is 0.20,
wherein $\lambda^{fluo}$ max is the absolute value of the maximum fluorescent emission peak wavelength, determined according to the method given in the determination methods and expressed in nm, and $\lambda^{abs}$ max is the absolute value of the maximum absorption peak wavelength, determined according to the method given in the determination methods and expressed in nm.

The one or more photosensitizers (S) having a structure according to formula (I) are preferably present in a total amount in the range from 0.1 to 10.0 wt.-%, more preferably in the range from 0.2 to 8.0 wt.-%, most preferably in the range from 0.3 to 6.0 wt.-%, relative to the total weight of the photopolymerizable composition (PC).

**One or more further photosensitizers having a structure other than formula (I)**

One of the optional components of the photopolymerizable composition (PC) according to the present invention is one or more further photosensitizers having a structure other than formula (I).

The one or more further photosensitizers are compounds that improve the performance of the photoinitiator in a

similar manner to the one or more photosensitizers (S) having a structure according to formula (I).

The person skilled in the art would be well aware that any chemical compound that absorbs light and re-emits the light via fluorescence could be used. Examples of such compounds include fluorophores, laser dyes and optical brighteners. These compounds have been used in various fields for various purposes, for instance optical brighteners have been employed in laundry detergents, in paper manufacturing, cosmetics, and textile whitening, as well as in some photopolymerizable compositions for the purpose of improving the optical properties of the cured composition, whilst laser dyes have been used as lasing medium in lasers, enabling a much wide range of wavelengths to be accessible.

In the broadest sense, any compound known for use as an optical brightener may be used in the photoinitiator package according to the present invention.

Examples of such well-known optical brighteners include compounds with building blocks including stilbene, triazine, thioazole, benzoxale, coumarin, xanthene, triazole, oxazole, thiophene and pyrazoline.

Particularly preferred are optical brighteners having coumarin or (benz)oxazole cores.

In a first particularly preferred embodiment, at least one of the one or more further photosensitizers has a structure according to formula (IX):

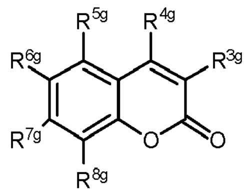

(IX)

wherein $R^{3g}$ is selected from the group consisting of hydrogen, $C_1$-$C_{10}$ alkyl, $C_6$-$C_{14}$ aryl, and $C_6$-$C_{14}$ heteroaryl, $R^{4g}$ is selected from the group consisting of hydrogen, $C_1$-$C_{10}$ alkyl, and $OR^{1g}$, and each of $R^{5g}$ to $R^{8g}$ is independently selected from the group consisting of hydrogen, halogen, alkyl, $OR^{1g}$, and $NR^{2g}{}_2$; wherein each instance of $R^{1g}$ is selected from hydrogen, $C_1$-$C_{10}$ alkyl and $C_6$-$C_{14}$ aryl, and each instance of $R^{2g}$ is selected from hydrogen, $C_1$-$C_{10}$ alkyl and $C_6$-$C_{14}$ aryl, wherein each instance of $R^{1g}$ to $R^{8g}$ may optionally be joined to one or more further instances of $R^{1g}$ to $R^{8g}$ to form one or more 5-membered or 6-membered rings.

In one preferred embodiment, $R^{3g}$ is selected from the group consisting of hydrogen and $C_1$-$C_{10}$ alkyl, or $R^{4g}$ is selected from the group consisting of hydrogen and $C_1$-$C_{10}$ alkyl.

In another preferred embodiment, $R^{3g}$ is selected from the group consisting of hydrogen and $C_1$-$C_{10}$ alkyl, and $R^{4g}$ is selected from the group consisting of hydrogen and $C_1$-$C_{10}$ alkyl.

In another preferred embodiment, $R^{7g}$ is selected from the group consisting of $OR^{1g}$, and $NR^{2g}{}_2$, most preferably $R^{7g}$ is $NR^{2g}{}_2$.

In a particularly preferred embodiment, $R^{3g}$ is selected from the group consisting of hydrogen and $C_1$-$C_{10}$ alkyl or $R^{4g}$ is selected from the group consisting of hydrogen and $C_1$-$C_{10}$ alkyl, whilst $R^{7g}$ is selected from the group consisting of $OR^{1g}$, and $NR^{2g}{}_2$, most preferably $R^{7g}$ is $NR^{2g}{}_2$.

In an especially preferred embodiment, $R^{3g}$ is selected from the group consisting of hydrogen and $C_1$-$C_{10}$ alkyl, $R^{4g}$ is selected from the group consisting of hydrogen and $C_1$-$C_{10}$ alkyl, and $R^{7g}$ is selected from the group consisting of $OR^{1g}$, and $NR^{2g}{}_2$, most preferably $R^{7g}$ is $NR^{2g}{}_2$.

At least one of, preferably all of, the further coumarin-based photosensitizers are selected from the group consisting of coumarin, 7-amino-4-(trifluoromethyl)coumarin, 3-(2-benzothiazolyl)-7-(diethylamino)coumarin, 7-hydroxy-4-(trifluoromethyl)coumarin, 7-(ethylamino)-4,6-dimethylcoumarin, 7-methoxy-4-(trifluoromethyl)coumarin, 7-ethoxy-4-(trifluoromethyl)coumarin, 7-amino-4-methylcoumarin, 7-(diethylamino)-4-methylcoumarin, 3-(2-benzoxazolyl)-7-(diethylamino)coumarin, 7-methylcoumarin, 7-methoxycoumarin, 4-hydroxycoumarin, 5,7-dimethoxycoumarin, 3-(3-biphenyl-4-yl-1,2,3,4-tetrahydro-1-naphthyl)-4-hydroxycoumarin, 6-methylcoumarin, 3-chloro-7-hydroxy-4-methylcoumarin, 7-hydroxycoumarin, 7-hydroxy-6-methoxycoumarin, 7-methoxy-6-hydroxycoumarin, 6-hydroxycoumarin, 7,8-dihydroxy-4-methylcoumarin, 7-Hydroxy-4-methylcoumarin, 7-(dimethylamino)-4-methylcoumarin, 2,3,6,7-Tetrahydro-9-methyl-1*H*,5*H*,11*H*-[1]benzopyrano[6,7,8-ij]quinolizin-1 1-one, 7-(diethylamino)-4-(trifluoromethyl)-coumarin, and 7-(ethylamino)-4-(trifluoromethyl)coumarin.

More preferably, at least one of, preferably all of, of the further coumarin-based photosensitizers are selected from the group consisting of coumarin, 3-(2-benzothiazolyl)-7-(diethylamino)coumarin, 7-methoxy-4-(trifluoromethyl) coumarin, 7-ethoxy-4-(trifluoromethyl)coumarin, 7-(diethylamino)-4-methylcoumarin, 3-(2-benzoxazolyl)-7-(diethylamino)coumarin, 7-methylcoumarin, 7-methoxycoumarin, 5,7-dimethoxycoumarin, 6-methylcoumarin, 7-(dimethylamino)-4-methylcoumarin, 2,3,6,7-Tetrahydro-9-methyl-1*H*,5*H*,11*H*-[1]benzopyrano[6,7,8-*ij*]quinolizin-11-one, 7-(diethylamino)-4-(trifluoromethyl)-coumarin, and 7-(ethylamino)-4-(trifluoromethyl)coumarin.

Most preferably, at least one of, preferably all of, of the further coumarin-based photosensitizers are selected from the group consisting of coumarin, 7-(diethylamino)-4-methylcoumarin, 7-methylcoumarin, 7-methoxycoumarin, 5,7-dimethoxycoumarin, and 7-(diethylamino)-4-(trifluoromethyl)-coumarin.

In a second particularly preferred embodiment, at least one of the one or more further photosensitizers has a structure according to formula (X):

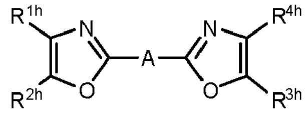
(X)

wherein each of $R^{1h}$ to $R^{4h}$ is independently selected from the group consisting of hydrogen, $C_1$-$C_{10}$ alkyl and $C_6$-$C_{14}$ aryl, wherein $R^{1h}$ and $R^{2h}$ may be joined to form a 6-membered saturated or unsaturated ring, which may be substituted by one or more substituents selected from the group consisting of hydrogen $C_1$-$C_{10}$ alkyl and $C_6$-$C_{14}$ aryl and wherein $R^{3h}$ and $R^{4h}$ may be joined to form a 6-membered saturated or unsaturated ring, which may be substituted by one or more substituents selected from the group consisting of hydrogen $C_1$-$C_{10}$ alkyl and $C_6$-$C_{14}$ aryl; and

wherein A represents a linking group represented by any of the following formulas (XI) to (XV):

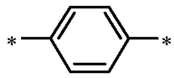
(XI)

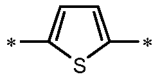
(XII)

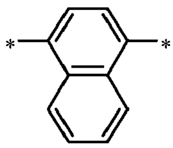
(XIII)

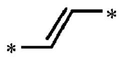
(XIV)

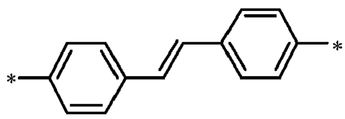
(XV)

wherein each * represents a bonding position of A in each formula.

Each of $R^{1h}$ to $R^{4h}$ is independently selected from the group consisting of hydrogen, $C_1$-$C_{10}$ alkyl and $C_6$-$C_{14}$ aryl, wherein $R^{1h}$ and $R^{2h}$ may be joined to form a 6-membered saturated or unsaturated ring, which may be substituted by one or more substituents selected from the group consisting of hydrogen $C_1$-$C_{10}$ alkyl and $C_6$-$C_{14}$ aryl and wherein $R^{3h}$ and $R^{4h}$ may be joined to form a 6-membered saturated or unsaturated ring, which may be substituted by one or more substituents selected from the group consisting of hydrogen $C_1$-$C_{10}$ alkyl and $C_6$-$C_{14}$ aryl.

In one embodiment, each of $R^{1h}$ to $R^{4h}$ is independently selected from the group consisting of hydrogen, $C_1$-$C_6$ alkyl and $C_6$-$C_{10}$ aryl.

In a particularly preferred embodiment, both $R^{1h}$ and $R^{3h}$ are joined to $R^{2h}$ and $R^{4h}$, respectively, to form 6-membered saturated or unsaturated rings, which may be substituted by one or more substituents selected from the group consisting of hydrogen $C_1$-$C_{10}$ alkyl and $C_6$-$C_{14}$ aryl.

In one embodiment of said particularly preferred embodiment, each 6-membered ring formed is aromatic, meaning that at least one of the the one or more oxazole-based photosensitizers is a benzoxazole-based photosensitizers, having a structure according to formula (XVI):

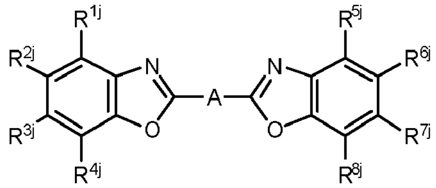

(XVI)

wherein each of $R^{1j}$ to $R^{8j}$ is independently selected from the group consisting of hydrogen, $C_1$-$C_{10}$ alkyl and $C_6$-$C_{14}$ aryl.

Preferably each of $R^{1j}$ to $R^{8j}$ is independently selected from the group consisting of hydrogen, $C_1$-$C_6$ alkyl and $C_6$-$C_{10}$ aryl.

In one embodiment, each of the one or more oxazole-based photosensitizers has a structure according to formula (XVI).

In other embodiments, at least one of the one or more oxazole-based photosensitizers has a structure according to formula (XVI), whilst any remaining oxazole-based photosensitizers in the photoinitiator package have other structures according to formula (X).

Particularly preferred compounds according to Formula (X) include 2,5-thiophenediylbis(5-tert-butyl-1,3-benzoxazole), 2,2'-(vinylenedi-p-phenylene)bisbenzoxazole, 2,2'-(naphthalene-1,4-diyl)bis(benzoxazole), 2-[4-[2-[4-(benzoxazol-2-yl)phenyl]vinyl]phenyl]-5-methylbenzoxazole, 2,2'-(1,4-phenylene)bis[5-phenyl-oxazole].

Further examples of photosensitizers are those commonly used in the art, aromatic carbonyl compounds, e.g. benzophenones, thioxanthones, anthraquinones, and 3-acylcoumarin derivatives, terphenyls, styryl ketones, and 3-(aroylmethylene)-thiazolines, camphorquinones and also eosin, rhodamine and erythrosine dyes.

Examples of thioxanthones are thioxanthone, 2-isopropyl thioxanthone, 2-chloro thioxanthone, 2-dodecyl thioxanthone, 2,4-diethyl thioxanthone, 2,4-dimethyl thioxanthone, 1-methoxycarbonyl thioxanthone, 2-ethoxycarbonyl thioxanthone, 3-(2-methoxyethoxycarbonyl) thioxanthone, 4-butoxycarbonyl thioxanthone, 3-butoxycarbonyl-7-methyl thioxanthone, 1-cyano-3-chloro thioxanthone, 1-ethoxycarbonyl-3-chloro thioxanthone, 1-ethoxycarbonyl-3-ethoxy thioxanthone, 1-ethoxycarbonyl-3-amino thioxanthone, 1-ethoxycarbonyl-3-phenylsulfuryl thioxanthone, 3,4-di[2-(2-methoxyethoxy)ethoxycarbonyl] thioxanthone, 1-ethoxycarbonyl-3-(1-methyl-1-morpholinoethyl) thioxanthone, 2-methyl-6-dimethoxymethyl thioxanthone, 2-methyl-6-(1,1-dimethoxybenzyl) thioxanthone, 2-morpholinomethyl thioxanthone, 2-methyl-6-morpholinomethyl thioxanthone, N-allylthioxanthone-3,4-dicarboximide, N-octylthioxanthone-3,4-dicarboximide, N-(1,1,3,3-tetramethylbutyl)-thioxanthone-3,4-dicarboximide, 1-phenoxy thioxanthone, 6-ethoxycarbonyl-1-2-methoxythioxanthone, 6-ethoxycarbonyl-2-methylthioxanthone, thioxanthone-2-polyethylene glycol ester, 2-hydroxy-3-(3,4-dimethyl-9-oxo-9H-thioxanthon-2-yloxy)-N,N,N-trimethyl-1-propanaminium chloride, or those described in the patent application PCT/EP2011/069514, such as n-dodecyl-7-methyl-thioxanthone-3-carboxylate and N,N-disobutyl-7-methyl-thioxanthone-3-carbamide. Also suitable are polymeric thioxanthone derivatives (e.g. Omnipol® TX from IGM Resins B.V., Genopol® TX-1 from Rahn A.G., Speedcure® 7010 from Lambson Limited).

Example of benzophenones are benzophenone, 4-phenyl benzophenone, 4-methoxy benzophenone, 4,4'-dimethoxybenzophenone, 4,4'-dimethyl benzophenone, 4,4'-dichloro benzophenone, 4,4'-dimethylamino benzophenone, 4,4'-diethylamino benzophenone, 4-methyl benzophenone, 2,4,6-trimethyl benzophenone, 4-(4-methylthiophenyl) benzophenone, 3,3'-dimethyl-4-methoxy benzophenone, methyl 2-benzoyl benzoate, 4-(2-hydroxyethylthio) benzophenone, 4-(4-tolylthio) benzophenone, 4-benzoyl-N,N,N-trimethylbenzene methanaminium chloride, 2-hydroxy-3-(4-benzoylphenoxy)-N,N,N-trimethyl-1-propanaminium chloride monohydrate, 4-(13-acryloyl-1,4,7,10,13-pentaoxatridecyl) benzophenone, 4-benzoyl-N,N-dimethyl-N-[2-(1-oxo-2-propenyl)oxylethyl-benzene methanaminium chloride, or those described in US9938231 (e.g. Omnirad® 991 from IGM Resins B.V.).

Also suitable are polymeric benzophenone derivatives (e.g. Omnipol® BP, Omnipol® 2702 and Omnipol® 682 all from IGM Resins B.V., Genopol® BP-2 from Rahn A.G. and Speedcure® 7005 from Lambson Limited).

Examples of 3-acylcoumarin derivatives are 3-benzoyl coumarin, 3-benzoyl-7-methoxy coumarin, 3-benzoyl-5,7-di(propoxy) coumarin, 3-benzoyl-6,8-dichloro coumarin, 3-benzoyl-6-chloro coumarin, 3,3'-carbonyl-bis[5,7-di(propoxy) coumarin], 3,3'-carbonyl-bis(7-methoxy coumarin), 3,3'-carbonyl-bis(7-diethylamino coumarin), 3-isobutyroyl coumarin, 3-benzoyl-5,7-dimethoxy coumarin, 3-benzoyl-5,7-diethoxy coumarin, 3-benzoyl-5,7-dibutoxy coumarin, 3-benzoyl-5,7-di(methoxyethoxy) coumarin, 3-benzoyl-5,7-di(allyloxy) coumarin, 3-benzoyl-7-dimethylamino coumarin, 3-benzoyl-7-diethylamino coumarin, 3-isobutyroyl-1,7-dimethylamino coumarin, 5,7-dimethoxy-3-(1-naphthoyl) coumarin, 5,7-dimethoxy-3(1-naphthoyl)-coumarin, 3-benzoylbenzo [f]coumarin, 7-diethylamino-3-thienoyl coumarin, 3-(4-cyanobenzoyl)-5,7-dimethoxy coumarin, or those described in EP2909243 and WO2017216699.

Examples of 3-(aroylmethylene) thiazolines are 3-methy-1,2-benzoylmethylene-β-naphtho thiazoline, 3-methyl-2-benzoylmethylene-benzo thiazoline, 3-ethyl-2-propionylmethylene- β -naphtho thiazoline.

Examples of other aromatic carbonyl compounds are acetophenone, 3-methoxyacetophenone, 4-phenylacetophenone, benzil, such as that described in WO 2013/164394, 2-acetylnaphthalene, 2-naphthaldehyde, 9,10-anthraquinone, 9-fluorenone, dibenzosuberone, xanthone, 2,5-bis(4-diethylaminobenzylidene) cyclopentanone, α-(para-dimethylamino benzylidene), ketones, such as 2-(4-dimethylamino-benzylidene)-indan-1-one or 3-(4-dimethylaminophenyl)-1-indan-5-yl-propenone, 3-phenylthiophthalimide, N-methyl-3,5-di(ethylthio) phthalimide.

Particularly preferred are thioxanthones, and 3-acylcoumarins.

It was observed that the above photosensitizers increase the activity of the one or more bisacylphosphine oxide photoinitiators without shortening the shelf life of the compositions. Moreover, such compositions have the special advantage that an appropriate choice of the photosensitizer allows the spectral sensitivity of the photoinitiator package to be shifted to any desired wavelength region. The person skilled in the art is able to select the suitable photosensitizer to make the photoinitiator package work at any desired wavelength region.

If present, the one or more further photosensitizers having a structure other than formula (I) are present in a total amount in the range from 0.1 to 10.0 wt.-%, more preferably in the range from 0.3 to 5.0 wt.-%, most preferably in the range from 0.5 to 3.0 wt.-%, relative to the total weight of the photopolymerizable composition (PC).

It is preferred that no further sensitizers having a structure other than formula (I) are present.

## One or more amines

One of the optional components of the photopolymerizable composition (PC) according to the present invention is one or more amines.

The presence of amines in Norrish Type-I photoinitiator-based photopolymerizable compositions, in combination with some photosensitizers, can drastically improve the rate of curing, in particular surface curing.

In the broadest sense, the one or more amines according to the present invention may be any amine, including aliphatic, cycloaliphatic, aromatic, aryl aliphatic, heterocyclic, oligomeric or polymeric amines. They may be primary, secondary or tertiary amines, for example, butyl amine, dibutylamine, tributylamine, cyclohexyl amine, benzyldimethyl amine, dicyclohexyl amine, N-phenyl glycine, triethyl amine, phenyl-diethanol amine, triethanolamine, piperidine, piperazine, morpholine, quinolone, esters of dimethylamino benzoic acid, and corresponding derivatives. Furthermore, amine-modified acrylates can be used. Examples of such amine-modified acrylates include acrylates modified by reaction with a primary or secondary amine that are 15 described in US 3,844,916, EP 280222, US 5,482,649 or US 5,734,002.

Multifunctional amine and polymeric amine derivatives are also suitable for use are Omnipol ASA from IGM Resins B.V., Genopol AB-2 from Rahn A.G., Speedcure 7040 from Lambson Limited or those described in US2013/0012611.

It would be understood by the person skilled the art that the term "amine" does not include amides or imides, irrespective of whether the nitrogen of the amide/imide is bonded to an alkyl group. Likewise, ammonium salts would not be amines.

It is preferred that the one or more amines are not Type-I or Type-II photoinitiators, such as well-known aminoketone Type-I initiators. It is further preferred that the one or more amines are not optical brighteners, i.e. compounds that absorb light in the ultraviolet and violet region of the EM-spectrum and re-emits the light in the blue region via fluorescence. As such, it is clear that the only role of the amine in the photopolymerization package is to act as a synergist, improving the effect of the one or more one or more photoinitiators and/or the one or more photosensitizers (S) having a structure according to formula (I).

It is preferred that the one or more amines have a so-called alpha-hydrogen, i.e. a hydrogen bonded to a carbon that is directly bonded to the nitrogen of the amine. It is particularly preferred that this hydrogen is bonded to an $sp^3$-hybridized carbon. As such, it is preferred that the amine has a nitrogen atom having a direct single bond to either a methyl group (i.e. $CH_3$), a methylene group (i.e. the $CH_2$ of a $CH_2R$) or a methanetriyl group (i.e. the CH of a $CHR_2$).

Without wishing to be bound by theory, it is believed that the alpha-hydrogen may be easily abstracted by radicals, forming a stabilized alpha-amino-radical, which can play a role in improving the rate of curing, in particular by scavenging molecular oxygen, which may retard the polymerization reaction.

It is particularly preferred that the nitrogen atom is bonded to at least one alkyl group. It is further preferred that the nitrogen atom is bounded to at least two alkyl groups.

In one particularly preferred embodiment, the one or more amines are independently selected from the group consisting of amines having the formula $NR^AR^BR^C$, wherein $R^A$ and $R^B$ are independently selected from optionally substituted alkyl groups and $R^C$ is selected from the group consisting of optionally substituted alkyl groups and optionally substituted aryl groups.

In said embodiment, the term "optionally substituted aryl groups" does not include aryl groups that have two or more substituents that are linked to form a fused ring system, such as a quinoline, an indole, or a coumarin. Likewise, the term "optionally substituted alkyl groups" does not include substitution that would result in the group no longer being considered as an alkyl group, such as acyl groups (i.e. =O substitution at the first carbon atom of the alkyl chain).

If present, the one or more amines are present in a total amount in the range from 0.1 to 10.0 wt.-%, more preferably in the range from 0.3 to 5.0 wt.-%, most preferably in the range from 0.5 to 3.0 wt.-%, relative to the total weight of

the photopolymerizable composition (PC).

### One or more pigments

Another optional component of the photopolymerizable composition (PC) according to the present invention is one or more pigments.

Any pigment known to the person skilled in the art may be used in the photopolymerizable composition.

Depending upon the intended use, both inorganic and organic pigments may be used. Such additives are well known to the person skilled in the art; some examples are carbon black, iron oxides, such as iron oxide yellow, iron oxide red, chromium yellow, chromium green, nickel titanium yellow, ultramarine blue, cobalt blue, bismuth vanadate, cadmium yellow and cadmium red. Examples of organic pigments are mono- or bis-azo pigments, and also metal complexes thereof, phthalocyanine pigments, polycyclic pigments, e.g. perylene, anthraquinone, thioindigo, quinacridone or triphenylmethane pigments, and also diketo-pyrrolo-pyrrole, isoindolinone, e.g. tetrachloroisoindolinone, isoindoline, dioxazine, benzimidazolone and quinophthalone pigments. The pigments may be used in the formulations individually or in admixture

If present, the one or more pigments are present in a total amount in the range from 0.1 to 30 wt.-%, more preferably in the range from 1.0 to 25 wt.-%, most preferably in the range from 10 to 20 wt.-%, relative to the total weight of the photopolymerizable composition (PC).

### One or more binders

Another of the optional components of the photopolymerizable composition (PC) according to the present invention is one or more binders.

The addition of binders is particularly advantageous when the ethylenically unsaturated, free-radical polymerizable compound(s) are liquid or viscous substances. The choice of binder is made in accordance with the field of use and the properties required therefor, such as developability in aqueous and organic solvent systems, adhesion to substrates and sensitivity to oxygen. Suitable binders are, for example, polymers having a weight average molecular weight (Mw) of approximately from 5,000 Da to 2,000,000 Da, preferably from 10,000 Da to 1,000,000 Da. Illustrative examples are: homo- and copolymers of acrylates and methacrylates, e.g. copolymers of methyl methacrylate/ethyl acrylate/methacrylic acid, poly(methacrylic acid alkyl esters), poly(acrylic acid alkyl esters); cellulose esters and ethers, such as cellulose acetate, cellulose acetate butyrate, methylcellulose, ethylcellulose, polyvinylbutyral, polyvinylformal, cyclised rubber, polyethers such as polyethylene oxide, polypropylene oxide, polytetrahydrofuran, polystyrene, polycarbonates, polyurethanes, chlorinated polyolefins, e.g. polyvinyl chloride, co-polymers of vinyl chloride/vinylidene chloride, co-polymers of vinylidene chloride with acrylonitrile, methyl methacrylate and vinyl acetate, polyvinyl acetate, co-poly (ethylene/vinyl acetate), polymers such as polycaprolactam and poly(hexamethylene adipamide), polyesters such as poly(ethylene glycol terephthalate) and poly(hexamethylene glycol succinate).

If present, the one or more binders are present in a total amount in the range from 5.0 to 60 wt.-%, more preferably in the range from 8.0 to 50 wt.-%, most preferably in the range from 10 to 40 wt.-%, relative to the total weight of the photopolymerizable composition (PC).

### One or more additives

The final optional component of the photopolymerizable composition (PC) according to the present invention is one or more additives.

The choice of additives is governed by the field of use in question and the properties desired for that field. Typical additives include thermal initiators, stabilizers, light stabilizers, fillers, colorants, antistatic agents, wetting agents, flow improvers, and adhesion enhancers.

For instance, especially in the case of pigmented compositions, the composition may also comprise, as additional additive, a thermal initiator, a compound that forms free radicals when heated, e.g. an azo compounds, such as 2,2'-azobis(4-methoxy-2,4-dimethylvaleronitrile), a triazene, diazo sulfide, pentazadiene or a peroxy compound, for example a hydroperoxide or peroxycarbonate, e.g. tert-butyl hydroperoxide, as described e.g. in EP 245 639.

Suitable stabilizers are, for example, thermal inhibitors, such as hydroquinone, hydroquinone derivatives, p-methoxyphenol, β-naphthol or sterically hindered phenols, e.g. 2,6-di(tert-butyl)-p-cresol, which prevent premature polymerization. In order to increase dark storage stability it is possible to use, for example, copper compounds, such as copper naphthenate, stearate or octoate, phosphorus compounds, for example triphenylphosphine, tributylphosphine, triethyl phosphite, triphenyl phosphite or tribenzyl phosphite, quaternary ammonium compounds, e.g. tetramethylammonium chloride or trimethylbenzylammonium chloride, or hydroxylamine derivatives, e.g. N,N-diethylhydroxylamine. For the purpose of excluding atmospheric oxygen during polymerization it is possible to add paraffin or similar wax-like

substances which, being insoluble in the polymer, migrate to the surface at the beginning of the polymerization and form a transparent surface layer which prevents air from entering.

It is also possible to add a light stabilizer, such as UV absorbers, e.g. hydroxyphenylbenzotriazole, hydroxyphenylbenzophenone, oxalic acid amide or hydroxyphenyl-s-triazine type. Such components can be used on their own or in the form of mixtures, with or without the use of sterically hindered amines (HALS).

If present, the one or more additives are present in a total amount in the range 0.01 to 10 wt.-%, more preferably in the range from 0.01 to 8.0 wt.-%, most preferably in the range from 0.01 to 5.0 wt.-%, relative to the total weight of the photopolymerizable composition (PC).

Compounds

In a second aspect, the present invention is directed to a compound selected from the group consisting of:

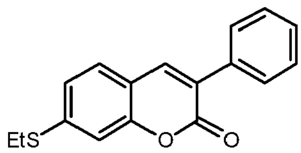
,
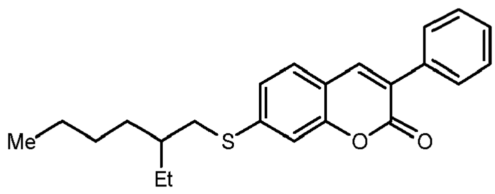
,

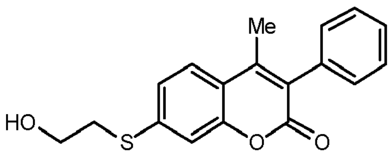
,
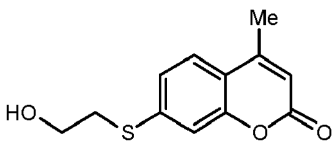
,
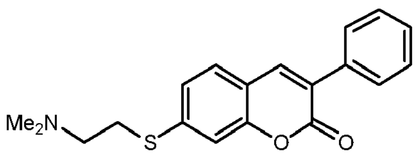
,

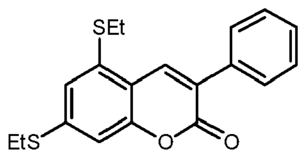
, and
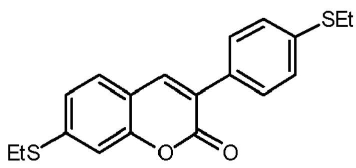
.

## Method

In a third aspect, the present invention is directed to a method for photocuring photopolymerizable compositions, coatings, adhesives and inks, said method comprising the following steps in the given order:

a) coating or printing the photopolymerizable composition (PC) according to any one of the preceding claims onto a substrate, and
b) photopolymerizing said coated or printed composition with a light source on said substrate.

Preferably the light source operates in the near-UV or visible range of the EM-spectrum.

All fallback positions and preferable embodiments of the photopolymerizable composition (PC) described above or below are applicable mutatis mutandis to the method for photocuring photopolymerizable compositions, coatings, adhesives and inks according to the present aspect.

Uses

In a fourth aspect, the present invention is directed to a use of a compound having a structure according to formula (I):

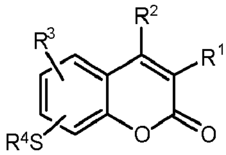
(I)

wherein $R^1$ and $R^2$ are independently selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein $R^3$ represents from 0 to 3 substitutions, each being selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein $R^4$ is selected from the group consisting of $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein at least one of $R^1$ and $R^2$ is not hydrogen, and
wherein each instance of $R^1$ to $R^5$ may optionally be joined to one or more further instances of $R^1$ to $R^5$ to form one or more 5-membered or 6-membered rings,
for improving the performance of one or more Norrish Type-I photoinitiators.

In one embodiment, the performance of one or more Norrish Type-I photoinitiators is improved when the maximum tack free speed, determined according to the method given in the determination methods, and/or the maximum through cure speed, determined according to the method given in the determination methods, of the combination of Norrish Type-I photoinitiator with the compound having a structure according to formula (I) is higher than for Norrish Type-I photoinitiator used alone in an amount equivalent to the Norrish Type-I photoinitiator amount used in the combination (i.e. a 4 wt% PI + 1 wt% S is compared with 4 wt% of PI, rather than (4+1=) 5 wt% of PI).

In this embodiment, it is particularly preferred that the performance is improved when the maximum tack free speed and/or the maximum through cure speed is determined using a lamp selected from the group consisting of a UV Hg lamp with an intensity of 120 W/cm, a UV LED lamp with a wavelength of 395 nm and an intensity of 16 W/cm$^2$, and a UV LED lamp with a wavelength of 365 nm and an intensity of 16 W/cm$^2$.

All fallback positions and preferable embodiments of the one or more photosensitizers (S) according to formula (I) of the first aspect apply mutatis mutandis to the use of compound according to formula (I) of the fourth aspect.

In a final aspect, the present invention is directed to a use of one or more Norrish Type-I photoinitiators in combination with one or more compounds having a structure according to formula (I):

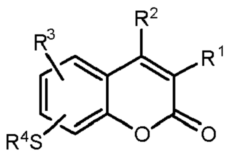
(I)

wherein $R^1$ and $R^2$ are independently selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein $R^3$ represents from 0 to 3 substitutions, each being selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein $R^4$ is selected from the group consisting of $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of the

group consisting of hydrogen, $C_1$-$C_{10}$ alkyl, and $C_6$-$C_{14}$ aryl,
wherein at least one of $R^1$ and $R^2$ is not hydrogen, and
wherein each instance of $R^1$ to $R^5$ may optionally be joined to one or more further instances of $R^1$ to $R^5$ to form one or more 5-membered or 6-membered rings,

in the production of printing inks, screen-printing inks, gravure printing inks, solder masks, etch offset-printing inks, flexographic- printing inks, gravure printing inks, inkjet inks, resist material, insulators, encapsulants, image-recording material, solder mask, passivation layer, protective coating, 3D-printing objects and molds, holographic applications, optical fiber coating, waveguide and lens, overprint varnish, wood, vinyl, metal and plastic coatings.

All fallback positions and preferable embodiments of the one or more photosensitizers (S) according to formula (I) and/or the Norrish Type-I photoinitiators described for the first aspect apply mutatis mutandis to the use of one or more Norrish Type-I photoinitiators in combination with one or more compounds having a structure according to formula (I) of the final aspect.

## EXAMPLES

### 1. Synthesis of thioalkylcoumarins

Definitions and apparatus:

r.t. = room temperature
s.s. = super saturated
$^1$H-NMR spectra were recorded with a Bruker Avance 400 MHz or a Bruker DMX 500 MHz or a Bruker DMX 600 MHz.
IR spectra were recorded with a FT-IR 430-Jasco.

4-Fluorosalicylaldehyde

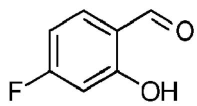

To an ice-cooled solution of 10.00 g of 3-fluorophenol (89.21 mmol) in acetonitrile (125 mL) were added 25.48 g of anhydrous MgCh (267.62 mmol) in 4 portions, keeping the temperature below 10 °C. Thereafter, 36.11 g of triethylamine (TEA) (356.82 mmol) were added by using a dropping funnel and keeping the temperature below 10 °C. Finally, the mixture was heated to reflux for 3h under $N_2$ atmosphere. The mixture was then allowed to reach r.t. and quenched by addition of 200 mL of 2 M HCl and stirred for 10 minutes. The mixture was diluted with 50 mL of EtOAc, and the layers were separated. The aqueous phase was extracted twice more with EtOAc (50 mL). Combined organic layers were dried over $Na_2SO_4$, filtered, and the solvent removed under reduced pressure to obtain 12.4 g of product as a brownish solid (99% yield).

$^1$H-NMR (DMSO-d6, $\delta$ ppm): 11.20 (s, 1H), 10.18 (s, 1H), 7.80-7.68 (t, 1H), 6.59-6.74 (m, 2H).

Compound 1

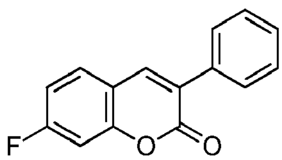

To a solution of 1.02 g of phenylacetic acid (7.50 mmol) in dry DCM (20 mL) cooled at 0 °C were added 1.22 g of carbonyldimiidazole (CDI) (7.50 mmol) and the mixture was stirred for 30 minutes under $N_2$ atmosphere. Thereafter, 1.00 g of 4-fluoro salicylaldehyde (7.14 mmol) were added to the mixture, followed by 1.09 g of 1,5-diazabiciclo(5.4.0)undec-7-ene (DBU) (7.14 mmol) and the mixture was allowed to reach r.t. and stirred for 1 hour more. The reaction was quenched by addition of 20 mL of 10% HCl and then the layers were separated. The organic one was further washed with 20 mL of $H_2O$, dried over $Na_2SO_4$, filtered, and the solvent removed under reduced pressure to obtain 1.27 g of product as a white solid

(74% yield).

$^1$H-NMR (DMSO-d6, δ ppm): 8.28 (s, 1H), 7.91-7.82 (m, 1H), 7.62-7.69 (dd, 2H), 7.52-7.39 (m, 4H), 7.34-7.25 (dt, 1H).

Compound 2

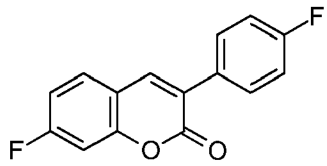

To a solution of 0.58 g of 4-fluoro phenylacetic acid (3.75 mmol) in dry DCM (10 mL) cooled at 0 °C were added 0.61 g of CDI (3.75 mmol) and the mixture was stirred for 30 minutes under $N_2$ atmosphere. Thereafter, 0.50 g of 4-fluoro salicylaldehyde (3.57 mmol) were added to the mixture, followed by 0.54 g of DBU (3.57 mmol) and the mixture was allowed to reach r.t. and stirred for 1 h more. The reaction was quenched by addition of 10 mL of 10% HCl and then the layers were separated. The organic one was further washed with 10 mL of $H_2O$, dried over $Na_2SO_4$, filtered, and the solvent removed under reduced pressure to obtain 0.48 g of product as a white solid (52% yield).

$^1$H-NMR (DMSO-d6, δ ppm): 8.23 (s, 1H), 7.90-7.73 (m, 1H), 7.39-7.20 (m, 3H), 7.19-7.08 (m, 3H).

Compound 3

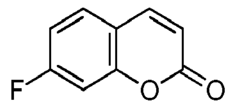

To a solution of 2.00 g of 4-fluoro salicylaldehyde (14.28 mmol) in acetic anhydride (Ac2O) (6.75 mL) were added 7.29 g of TEA (15.71 mmol) and the mixture was stirred at 140 °C for 48h. The mixture was allowed to cool down to r.t. and poured into 50 mL of 30% $NH_4OH$ and vigorously stirred for 10 minutes. The mixture was filtered, and the residue was washed with 20 mL of $H_2O$, then dissolved in DCM, dried over $Na_2SO_4$, and the solvent removed under reduced pressure. The residue was taken up in toluene and filtered on a small pad of $SiO_2$ to obtain 1.00 g of product as an off-white solid (43% yield).

$^1$H-NMR (DMSO-d6, δ ppm): 8.21-7.96 (d, 1H), 7.91-7.71 (t, 1H), 7.45-7.30 (d, 1H), 7.29-7.13 (t, 1H), 6.56-6.35 (d, 1H).

Compound 4

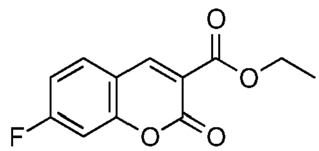

To a solution of 1.00 g of 4-fluoro salicylaldehyde (7.14 mmol) and 1.14 g of diethylmalonate (7.14 mmol) in EtOH (2 mL) were added 0.06 g of piperidine (0.71 mmol) and the mixture was stirred at reflux for 2h. Thereafter, the mixture was allowed to cool down to r.t. and poured into 20 mL of ice-cooled water. The solid formed was filtered out and dried under vacuum to obtain 1.36 g of product as a yellow solid (81% yield).

$^1$H-NMR (DMSO-d6, δ ppm): 8.77 (s, 1H), 8.07-7.94 (m, 1H), 7.48-7.38 (dd, 1H), 7.37-7.25 (dt, 1H), 4.37-4.23 (q, 2H), 1.38-1.26 (t, 3H).

Compound 5

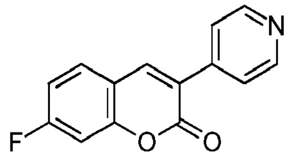

To a solution of 1.00 g of 4-piridylacetic acid hydrochloride (5.76 mmol) in dry DCM (10 mL) cooled at 0 °C were

added 0.93 g of CDI (5.76 mmol) and the mixture was stirred for 30 minutes under $N_2$ atmosphere. Thereafter, 0.77 g of 4-fluoro salicylaldehyde (5.49 mmol) were added to the mixture, followed by 1.75 g of DBU (3.57 mmol) and the mixture was allowed to reach r.t. and stirred for 1 h more. The reaction was quenched by addition of 10 mL of $H_2O$ and then the layers were separated. The organic one was further washed with 10 mL of $H_2O$ and 10 mL of brine, dried over $Na_2SO_4$, filtered, and the solvent removed under reduced pressure to obtain 0.55 g of product as a pale-yellow solid (41% yield).

$^1$H-NMR (DMSO-d6, δ ppm): 8.75-8.60 (d, 2H), 8.52 (s, 1H), 7.96-7.86 (m, 1H), 7.80-7.72 (m, 2H), 7.53-7.44 (dd, 1H), 7.39-7.29 (dt, 1H).

Compound 6 **(S1)**

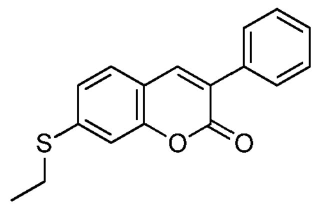

To a solution of 2.00 g of Compound 1 (8.32 mmol) in dry DMF (25 mL) were added 0.78 g of 90% sodium ethanethiolate (8.32 mmol) and the mixture was stirred at 40 °C for 1 h under $N_2$ atmosphere. Thereafter, the mixture was poured into 50 mL of $H_2O$ and extracted with EtOAc (2 x 25 mL). Combined organic layers were further washed with brine (2 x 50 mL), dried over $Na_2SO_4$, filtered, and the solvent removed under reduced pressure to obtain 2.25 g of product as a pale-yellow solid (95% yield).

$^1$H-NMR (DMSO-d6, δ ppm): 8.26 (s, 1H), 7.81-7.70 (m, 3H), 7.56-7.45 (m, 3H), 7.40-7.36 (d, 1H), 7.34-7.28 (dd, 1H), 3.25-3.09 (q, 2H), 1.44-1.28 (t, 3H).

Compound 7 **(S2)**

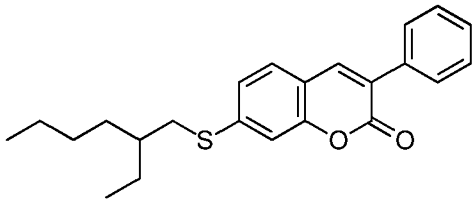

To a suspension of 0.09 g of 60% NaH in mineral oil (2.18 mmol) in dry DMF (2 mL) cooled at 0 °C were added 0.32 g of ethylhexyl thiol (2.18 mmol) and the mixture was stirred for 1 h under $N_2$ atmosphere. Thereafter, 0.50 g of **Compound 1** (2.08 mmol) were added and the mixture was warmed at 40 °C and stirred for 1 h. Finally, the solution was poured into 20 mL of $H_2O$ and extracted with DCM (3 x 10 mL). Combined organic layers were further washed with brine (2 x 20 mL), dried over $Na_2SO_4$, filtered, and the solvent removed under reduced pressure. The residue was purified by flash column chromatography on $SiO_2$ (60:40 PE/toluene) to obtain 0.50 g of product as a pale-yellow solid (63% yield).

$^1$H-NMR (DMSO-d6, δ ppm): 8.23 (s, 1H), 7.81-7.65 (m, 3H), 7.55-7.42 (m, 3H), 7.39-7.33 (d, 1H), 7.32-7.26 (dd, 1H), 3.15-3.06 (d, 2H), 1.74-1.55 (m, 1H), 1.54-1.38 (m, 4H), 1.37-1.18 (m, 4H), 0.99-0.85 (m, 6H).

Compound 8 **(S3)**

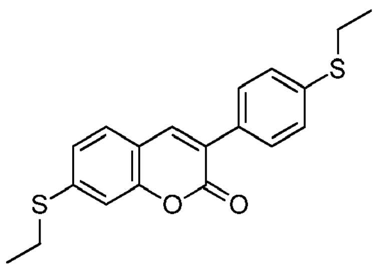

To a solution of 0.60 g of **Compound 2** (2.32 mmol) in dry DMF (2 mL) were added 0.43 g of 90% sodium ethanethiolate (4.64 mmol) and the mixture was stirred at 40 °C for 1 h under $N_2$ atmosphere. Thereafter, the mixture was poured into 20 mL of $H_2O$ and extracted with EtOAc (2 x 10 mL). Combined organic layers were further washed with brine (2

x 20 mL), dried over $Na_2SO_4$, filtered, and the solvent removed under reduced pressure to obtain 0.40 g of product as a pale-yellow solid (50% yield).

$^1$H-NMR (DMSO-d6, δ ppm): 8.20 (s, 1H), 7.84-7.72 (m, 1H), 7.36-7.23 (m, 3H), 7.21-7.06 (m, 3H), 3.19-3.04 (m, 4H), 1.37-1.21 (m, 6H).

Compound 9 **(S9)**

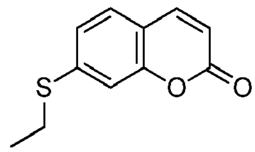

To a solution of 0.60 g of **Compound 3** (3.66 mmol) in dry DMF (2 mL) were added 0.34 g of 90% sodium ethanethiolate (3.66 mmol) and the mixture was stirred at 40 °C for 1 h under $N_2$ atmosphere. Thereafter, the mixture was poured into 20 mL of $H_2O$ and extracted with EtOAc (2 x 10 mL). Combined organic layers were further washed with brine (2 x 20 mL), dried over $Na_2SO_4$, filtered, and the solvent removed under reduced pressure to obtain 0.56 g of product as a pale-yellow solid (74% yield).

$^1$H-NMR (DMSO-d6, δ ppm): 8.04-7.98 (d, 1H), 7.86-7.76 (m, 1H), 7.66-7.60 (d, 1H), 7.44-7.36 (dd, 1H), 6.43-6.36 (d, 1H), 3.17-3.06 (q, 2H), 1.35-1.26 (t, 3H).

Compound 10 **(S10)**

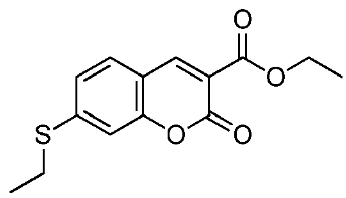

To a solution of 0.56 g of **Compound 4** (2.37 mmol) in dry DMF (2 mL) were added 0.22 g of 90% sodium ethanethiolate (2.37 mmol) and the mixture was stirred at 40 °C for 1 h under $N_2$ atmosphere. Thereafter, the mixture was poured into 20 mL of $H_2O$ and extracted with EtOAc (2 x 10 mL). Combined organic layers were further washed with brine (2 x 20 mL), dried over $Na_2SO_4$, filtered, and the solvent removed under reduced pressure to obtain 0.51 g of product as a pale-yellow solid (77% yield).

$^1$H-NMR (DMSO-d6, δ ppm): 8.76 (s, 1H), 8.05-7.96 (m, 1H), 7.46-7.38 (dd, 1H), 7.35-7.29 (m, 1H), 4.37-4.23 (q, 2H), 3.19-3.08 (q, 2H), 1.40-1.26 (m, 6H).

Compound 11 **(S11)**

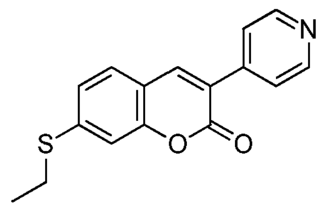

To a solution of 0.50 g of **Compound 5** (2.28 mmol) in dry DMF (5 mL) were added 0.21 g of 90% sodium ethanethiolate (2.28 mmol) and the mixture was stirred at 40 °C for 1 h under $N_2$ atmosphere. Thereafter, the mixture was poured into 20 mL of $H_2O$ and extracted with EtOAc (2 x 10 mL). Combined organic layers were further washed with brine (2 x 20 mL), dried over $Na_2SO_4$, filtered, and the solvent removed under reduced pressure. The residue was purified by flash column chromatography on $SiO_2$ (80:20 toluene/EtOAc) to obtain 0.20 g of product as a yellow solid (31% yield).

$^1$H-NMR (DMSO-d6, δ ppm): 8.68-8.65 (m, 2H), 8.45 (s, 1H), 7.79-7.76 (m, 2H), 7.74-7.69 (d, 1H), 7.38-7.73 (d, 1H), 7.33-7.28 (dd, 1H), 3.19-3.10 (q, 2H), 1.37-1.28 (t, 3H).

Compound 12 **(S4)**

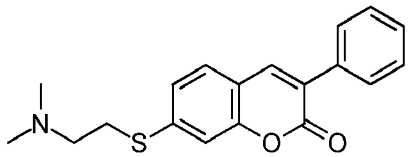

To a suspension of 0.22 g of 60% NaH in mineral oil (5.49 mmol) in dry DMF (2 mL) cooled at 0 °C were added 0.39 g of 2-dimethylamino ethanethiol (2.74 mmol) and the mixture was stirred for 1 h under $N_2$ atmosphere. Thereafter, 0.60 g of **Compound 1** (2.49 mmol) were added and the mixture was warmed at 40 °C and stirred for 1h. Finally, the solution was poured into 20 mL of $H_2O$ and extracted with DCM (3 x 10 mL). Combined organic layers were further washed with brine (2 x 20 mL), dried over $Na_2SO_4$, filtered, and the solvent removed under reduced pressure. The residue was purified by flash column chromatography on SiOz (60:40 PE/toluene) to obtain 0.58 g of product as a yellow solid (72% yield).

$^1$H-NMR (DMSO-d6, δ ppm): 8.26 (s, 1H), 7.80-7.71 (m, 3H), 7.55-7.45 (m, 3H), 7.41-7.38 (s, 1H), 7.35-7.30 (d, 1H), 3.31-3.23 (t, 2H), 2.65-2.57 (t, 2H), 2.25 (s, 6H).

Compound 13

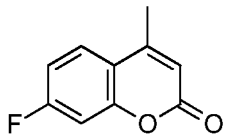

A mixture of 18.88 g of 4-fluoro-2-hydroxyacetophenone (122.47 mmol) and 61.42 g of methyl (triphenylphosphoranylidene)acetate (183.70 mmol) in 200 mL of toluene was stirred at reflux for 24 h. The mixture was allowed to cool down to r.t. and then it was concentrate to almost half of its volume and cooled to 0 °C until the formation of a precipitate under magnetic stirring. The solid was filtered out and further washed with toluene to obtain 16.96 g of product as a white solid (78% yield).

$^1$H-NMR (DMSO-d6, δ ppm): 7.59-7.56 (m, 1H), 7.04-7.0 (m, 2H), 6.23-6.22 (m, 1H), 2.42 (d, 3H).

Compound 14

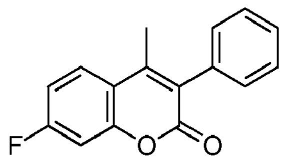

To a mixture of 1.00 g of 4-fluoro-2-hydroxyacetophenone (6.49 mmol) and 0.97 g of phenylacetic acid (7.14 mmol) in 2.00 mL of acetic anhydride were added 0.79 g of TEA (7.79 mmol) and the reaction was stirred at 100 °C for 3 h. The mixture was allowed to cool down to r.t. and then diluted with 20 mL and the organic phase was washed with $Na_2CO_3$ s.s. (2 x 10 mL) and water (20 mL), dried over $Na_2SO_4$, filtered, and the solvent removed under reduced pressure. The crude was crystallized from EtOH (6 mL) to obtain 1.04 g of product as an off-white solid (64% yield).

$^1$H-NMR (DMSO-d6, δ ppm): 8.03-7.87 (dd, 1H), 7.58-7.41 (m, 4H), 7.40-7.27 (m, 3H), 2.30 (s, 3H).

Compound 15 **(S5)**

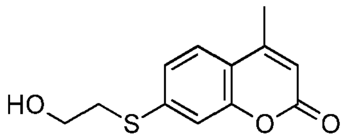

To a solution of 1.43 g of 2-mercaptoethanol (18.26 mmol) in 9 mL of dry toluene were added 0.67 g of NaOH (16.85 mmol) and the mixture was stirred at reflux with a Dean-Stark apparatus for 4 h. Thereafter, the solvent was removed by distillation with a Claisen apparatus and the residue was dissolved in 7 mL of dry DMF. Finally, 2.50 g of **Compound 13** (14.04 mmol) were added and the mixture was stirred at 55 °C for 1 h. The mixture was allowed to cool down to r.t., poured into 100 mL of $H_2O$ and extracted with DCM (2 x 50 mL). The organic layer dried over $Na_2SO_4$, filtered, and

the solvent removed under reduced pressure. The crude was crystallized from toluene (20 mL) to obtain 2.40 g of product as a white solid (74% yield).

$^1$H-NMR (DMSO-d6, δ ppm): 7.71-7.60 (d, 1H), 7.42-7.30 (d, 1H), 7.40-7.21 (dd, 1H), 6.30 (s, 1H), 5.09-4.96 (t, 1H), 3.70-3.58 (q, 2H), 3.23-3.18 (t, 2H), 2.41 (s, 3H).

Compound 16 **(S6)**

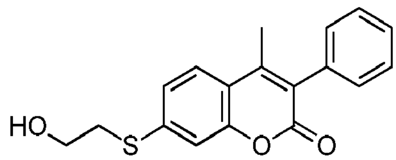

To a solution of 0.40 g of 2-mercaptoethanol (5.11 mmol) in 3 mL of dry toluene were added 0.19 g of NaOH (4.72 mmol) and the mixture was stirred at reflux with a Dean-Stark apparatus for 4h. Thereafter, the solvent was removed by distillation with a Claisen apparatus and the residue was disolved in 2 mL of dry DMF. Finally, 1.00 g of **Compound 14** (3.93 mmol) were added and the mixture was stirred at 55 °C for 1h. The mixture was diluted with 30 mL of EtOAc and then washed with $H_2O$ (2 x 50 mL) and brine (50 mL). The organic layer dried over $Na_2SO_4$, filtered, and the solvent removed under reduced pressure to obtain 1.18 g of product as an off-white solid (96% yield).

$^1$H-NMR (DMSO-d6, δ ppm): 7.73-7.62 (d, 1H), 7.55-7.49 (m, 3H), 7.48-7.30 (m, 4H), 5.09-5.00 (t, 1H), 3.71-3.62 (q, 2H), 3.24-3.18 (t, 2H), 2.21 (s, 3H).

Compound 17

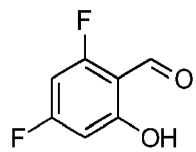

To an ice-cooled solution of 1.00 g of 3,5-difluorophenol (7.69 mmol) in acetonitrile (12.5 mL) were added 2.19 g of anhydrous $MgCl_2$ (23.06 mmol) in 4 portions, keeping the temperature below 10 °C. Thereafter, 3.11 g of TEA (30.75 mmol) were added by using a dropping funnel and keeping the temperature below 10 °C. Finally, the mixture was heated to reflux for 3 h under $N_2$ atmosphere. The mixture was allowed to reach r.t. and then quenched by addition of 20 mL of 2 M HCl and stirred for 10 minutes. The mixture was diluted with 20 mL of EtOAc, and the layers were separated. The aqueous phase was extracted twice more with EtOAc (20 mL). Combined organic layers were dried over $Na_2SO_4$, filtered, and the solvent removed under reduced pressure to obtain 120 g of product as an orange oil (99% yield)

$^1$H-NMR (DMSO-d6, δ ppm): 11.67 (s, 1H), 10.18 (s, 1H), 6.49-6.38 (m, 2H).

Compound 18

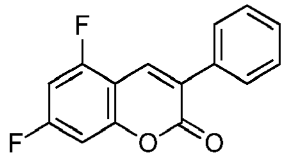

To a solution of 0.98 g of phenylacetic acid (7.26 mmol) in dry DCM (20 mL) cooled at 0 °C were added 1.18 g of CDI (7.26 mmol) and the mixture was stirred for 30 minutes under $N_2$ atmosphere. Thereafter, 1.10 g of **Compound 17** (6.92 mmol) were added to the mixture, followed by 1.05 g of DBU (6.92 mmol) and the mixture was allowed to reach r.t. and stirred for 1 h more. The reaction was quenched by addition of 20 mL of 10% HCl and then the layers were separated. The organic layer was further washed with 20 mL of $H_2O$, dried over $Na_2SO_4$, filtered, and the solvent removed under reduced pressure to obtain 1.00 g of product as a white solid (56% yield).

$^1$H-NMR (DMSO-d6, δ ppm): 8.13 (s, 1H), 7.78-7.73 (m, 2H), 7.52-7.42 (m, 3H), 7.41-7.35 (m, 2H).

Compound 19 (**S12**)

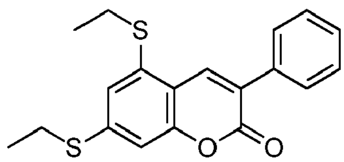

To a solution of 0.50 g of **Compound 18** (1.94 mmol) in dry DMF (2.50 mL) were added 0.72 g of 90% sodium ethanethiolate (7.74 mmol) and the mixture was stirred at 40 °C for 6 h under $N_2$ atmosphere. Thereafter, the mixture was poured into 20 mL of $H_2O$ and extracted with EtOAc (2 x 25 mL). Combined organic layers were further washed with brine (2 x 20 mL), dried over $Na_2SO_4$, filtered, and the solvent removed under reduced pressure to obtain 0.66 g of product as a yellow solid (98% yield).

$^1$H-NMR (DMSO-d6, δ ppm): 8.16 (s, 1H), 7.79-7.71 (dd, 2H), 7.58-7.46 (m, 3H), 7.29-7.24 (m, 2H), 3.27-3.12 (m, 4H), 1.42-1.28 (m, 6H).

Compound 20

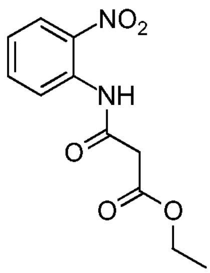

To a solution of 3.00 g of 2-nitroaniline (21.72 mmol) and 3.63 g of TEA (26.06 mmol) in 50 mL of DCM, cooled at 0 °C, were added 4.90 g of ethyl malonyl chloride (32.58 mmol). The reaction was allowed to warm to r.t. and stirred for 1 h under $N_2$ atmosphere. The mixture was then treated with 50 mL of NaHCOs s.s. and the layers were separated. The organic phase was further washed with water (50 mL) and brine (50 mL), dried over $Na_2SO_4$, filtered, and the solvent removed under reduced pressure to obtain 5.40 g of product as an orange oil (98% yield).

$^1$H-NMR (DMSO-d6, δ ppm): 10.55 (s, 1H), 8.03-7.94 (dd, 1H), 7.80-7.67 (m, 2H), 7.44-7.35 (m, 1H), 4.21-4.09 (q, 2H), 3.54 (s, 2H), 1.29-1.18 (t, 3H).

Compound 21

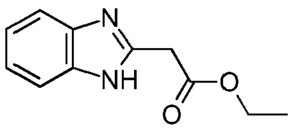

To a solution of 2.52 g of **Compound 20** (10 mmol) in 50 mL of glacial acetic acid were added 3.35 g of iron powder (60 mmol) and the mixture was stirred at reflux for 30 minutes. Thereafter, the solution was allowed to cool down to r.t. and then most of the volatiles were removed under reduced pressure. The residue was filtered on a small pad of celite and washed with 20 mL of DCM. The mixture was then treated with $Na_2CO_3$ s.s. until a pH of 8 and then the layers were separated. The organic phase was further washed with $H_2O$ (20 mL) and brine (20 mL), dried over $Na_2SO_4$, filtered, and the solvent removed under reduced pressure. The crude was purified by flash column chromatography on $SiO_2$ (1:1 EtOAc/toluene) to obtain 1.40 g of product as a pale-yellow solid (68% yield).

$^1$H-NMR (DMSO-d6, δ ppm): 12.34 (s, 1H), 7.62-7.40 (dd, 2H), 7.23-7.06 (m, 2H), 4.24-4.05 (q, 2H), 3.97 (s, 2H), 1.34-1.15 (t, 3H).

Compound 22

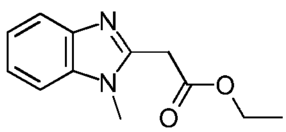

To a solution of 0.93 g of **Compound 21** (4.58 mmol) in 9.35 mL of dimethyl carbonate were added 0.70 g of DBU (4.58 mmol) and the mixture was stirred at 90 °C for 3 h. Thereafter, the reaction was allowed to cool down to r.t. and then 20 mL of water were added. The mixture was extracted with EtOAc (2 x 20 mL) and the organic phases were further washed with $H_2O$ (2 x 20 mL), dried over $Na_2SO_4$, filtered, and the solvent removed under reduced pressure to obtain 0.91 g of product an orange oil (92% yield).

MS[ESI]m/z = 219 [M+H]+

Compound 23

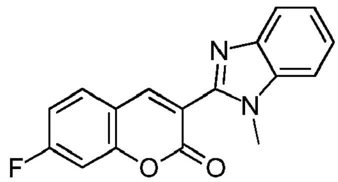

To a solution of 0.52 g of 4-fluoro salicylaldehyde (3.71 mmol) and 0.81 g of **Compound 22** (3.71 mmol) in EtOH (8 mL) were added 0.03 g of piperidine (0.37 mmol) and the mixture was stirred at reflux for 2 h. Thereafter, the mixture was allowed to cool down to r.t. and the solvent was removed under reduced pressure. The residue was purified by flash column chromatography on $SiO_2$ (80:20 toluene/EtOAc) to obtain 0.60 g of product as a yellow solid (55% yield).

$^1$H-NMR (DMSO-d6, δ ppm): 8.58 (s, 1H), 7.84-7.47 (m, 3H), 7.43-7.05 (m, 4H), 3.78 (s, 3H).

Compound 24 **(S7)**

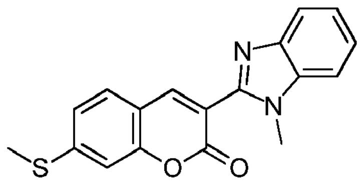

To a solution of 0.51 g of **Compound 23** (1.73 mmol) in dry DMF (5 mL) were added 0.12 g of sodium methanethiolate (1.73 mmol) and the mixture was stirred at 40 °C for 1 h under $N_2$ atmosphere. Thereafter, the mixture was poured into 20 mL of $H_2O$ and extracted with EtOAc (2 x 10 mL). Combined organic layers were further washed with brine (2 x 20 mL), dried over $Na_2SO_4$, filtered, and the solvent removed under reduced pressure to obtain 0.53 g of product as a yellow solid (95% yield).

$^1$H-NMR (DMSO-d6, δ ppm): 8.52 (s, 1H), 7.82-7.77 (d, 1H), 7.72-7.59 (dd, 2H), 7.42-7.24 (m, 4H), 3.78 (s, 3H), 2.64 (s, 3H).

**2. Evaluation of thioalkylcoumarins**

**2.1 Determination methods**

**Tack-free measurement:** Tack-free refers to a coating condition whereby a coating is completely cured on surface. It is evaluated as follows: the formulation is spread with a thickness of 12 microns on a varnished cardboard using a bar-coater and photopolymerized under a light source. Then the thumb of the operator is brought into contact with the coating with a slight pressure, if no fingerprints/signs remain on the surface the coating is perfectly cured. The maximum speed (m/min) at which no fingerprints/signs remain on the surface is given as value of tack-free. Higher maximum speeds correspond to higher reactivity.

**Through-cure measurement:** The through-cure test is a measurement of the complete ink cure obtained at a defined speed and checked by "thumb twist pressure test". It is evaluated as follows: the ink is homogenized with a mechanical stirrer for 1 hour at 50°C and applied onto a white cardboard at a thickness comprised between 1-1.5 microns using IGT repro-tester equipment.

The results of the through-cure measurement can be expressed as either the maximum speed (m/min) at which no signs remain on the surface (wherein higher speed corresponds to higher reactivity) of by the minimum light dose ($mJ/cm^2$) at which no signs remain on the surface (wherein lower light does corresponds to higher reactivity).

**Yellowness Index (YI):** is measured according to ASTM method E313, 'Standard Practice for Calculating Yellowness and Whiteness Indices from Instrumentally Measured Color Coordinates. The YI was made with the yellowing function D65/10° of Spectro-densitometer TECHKON SectroDens Premium (SN: C107028). Measurements were

performed after 24 hours from the crosslinking. The YI value recorded identifies the difference between the value of the support (used as reference) and the value of the coated film after curing. Lower numbers correspond to lower yellowing of the coated surface.

**Maximum absorption peak wavelength:** Absorption spectra have been recorded using an AnalytikJena S600 spectrophotometer. On a microbalance, the photosensitizer was weighted with a $10^{-6}$ g precision in a DSC crucible. The crucible and its content was transferred in volumetric flask, then filled with spectroscopic grade acetonitrile. The reference was taken for the empty spectrometer, and two series of spectra were recorded for each solution, in a 1 cm path and in a 1 mm path cells. The spectra of the solvent was taken separately in both cell and then subtracted to solutions spectra. The absorption maxima value is taken where the absorption spectra reaches its maximum in the region between (300 nm and 450 nm)

**Fluorescence emission peak wavelength:** Fluorescence spectra of the photosensitizers were recorded using a Horiba Jobin Yvon Fluoromax4 spectrofluorometer. The measurement for each photosensitizer was taken in a dilute solution (A ~0.1) of spectroscopic grade acetonitrile, using 1 cm path cell. The excitation wavelength was set at the maximum of absorption of the photosensitizer.

### 2.2 Materials used

The following commercially available compounds were used in the preparation of the inventive and comparative compositions:

- PI-1: bis(2,4,6-trimethylbenzoyl) phenylphosphine oxide, CAS #: 162881-26-7, commercially available as Omnirad 819 from IGM Group B. V. (NL).
- PI-2: bis(2,4,6-trimethylbenzoyl) octylphosphine oxide, prepared as in US 5534559 A.
- PI-3: 2,4,6-trimethylbenzoyl-diphenyl phosphine oxide, CAS #: 75980-60-8, commercially available as Omnirad TPO from IGM Group B. V. (NL).
- PI-4: ethyl(2,4,6-trimethylbenzoyl)-phenyl phosphinate, CAS #: 84434-11-7, commercially available as Omnirad TPO-L from IGM Group B. V. (NL).
- PI-5: bis(2,6-dimethoxybenzoyl)-2,4,-trimethylpentylphsophine oxide, CAS #: 145052-34-2, commercially available as Omnirad 403 from IGM Group B. V. (NL).
- S8: 7-diethylamino-4-methylcoumarin, CAS #: 91-44-1, commercially available as Coumarin 1 from Merck KGaA (DE).

Furthermore, the thioalkylcoumarins synthesized above were employed (with the structure of S8 given for reference):

| | | | |
|---|---|---|---|
| **S1** | 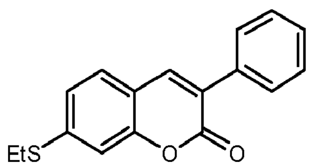 | **S7** | 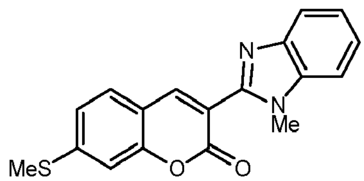 |
| **S2** | 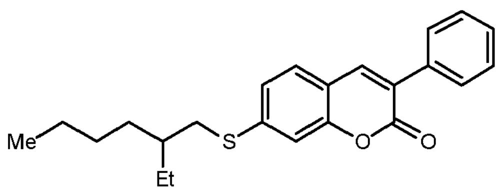 | **S8** | 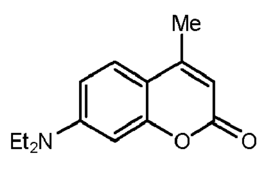 |
| **S3** | 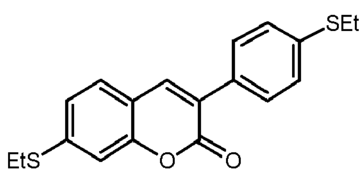 | **S9** | 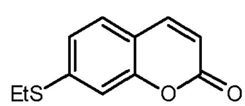 |

(continued)

| | | | |
|---|---|---|---|
| **S4** | 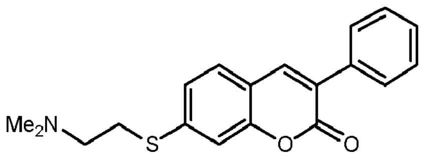 | **S10** | 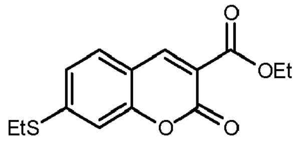 |
| **S5** | 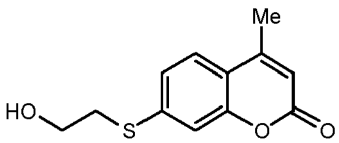 | **S11** | 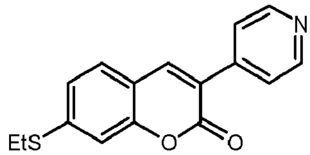 |
| **S6** | 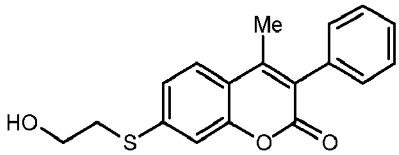 | **S12** | 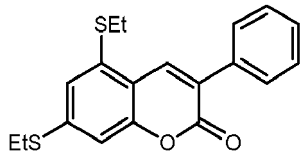 |

The absorption and emission maxima for these photosensitizers are given in Table 1.

**Table 1** Absorption/Emission data for S1 to S12

| | $\lambda^{abs}$ max | $\lambda^{fluo}$ max | | $\lambda^{abs}$ max | $\lambda^{fluo}$ max |
|---|---|---|---|---|---|
| **S1** | 345 nm | 440 nm | **S7** | 362 nm | 476 nm |
| **S2** | 352 nm | 411 nm | **S8** | 370 nm | 434 nm |
| **S3** | 347 nm | 439 nm | **S9** | 323 nm | 406 nm |
| **S4** | 351 nm | 435 nm | **S10** | n.m. | n.m. |
| **S5** | 330 nm | 396 nm | **S11** | n.m. | n.m. |
| **S6** | 335 nm | 424 nm | **S12** | n.m. | n.m. |

Of these structures, S1 to S6 and S12 have structures according to Formula (I).

**2.3 Evaluation of photosensitizers**

In Table 2, the following composition was tested for surface curing (i.e. the tack-free measurement method given in the determination methods), with the values given corresponding to tack-free max speed:
The photopolymerizable composition was prepared from 4 wt% of photoinitiator (any one of PI-1 to PI-5) and 1 wt% of photosensitizer (any one of S1 to S12), with the remainder being a monomer mixture (50:15:15:20 mixture of Photomer 6628:Photomer 4335:Photomer 4600:Photomer 4172 (all commercially available from IGM Group B. V. (NL)).
The yellowness index of the resultant compositions was also measured, with the resultant data displayed in parentheses in Table 2.

**Table 2** Performance of coumarin-based photosensitizers with various photoinitiators

| PI | S | Lamp 1 | Lamp 2 | Lamp 3 |
|---|---|---|---|---|
| PI-1 (4 wt%) | - | 60 (2.84) | 45 (1.63) | 70 (2.04) |
| PI-1 (5 wt%) | - | 78 (3.64) | 73 (2.68) | 85 (2.84) |
| PI-1 | S1 | 100 (2.82) | 100 (1.74) | 100 (1.64) |
| PI-1 | S2 | 92 (2.45) | 100 (1.77) | 100 (1.83) |
| PI-1 | S3 | 65 (2.28) | 80 (1.82) | 100 (1.81) |
| PI-1 | S4 | 75 (3.77) | 88 (2.00) | 99 (2.22) |

(continued)

| PI | S | Lamp 1 | Lamp 2 | Lamp 3 |
|---|---|---|---|---|
| PI-1 | S5 | 85 (2.70) | 42 (1.76) | 98 (1.85) |
| PI-1 | S6 | 85 (2.57) | 50 (1.31) | 100 (1.33) |
| PI-1 | S7 | 60 (12.91) | 40 (10.75) | 68 (10.37) |
| PI-1 | S8 | 95 (6.68) | 100 (7.67) | 100 (7.45) |
| PI-1 | S9 | 60 (2.17) | 40 (1.20) | 68 (1.67) |
| PI-1 | S10 | 60 (2.59) | 40 (2.27) | 68 (2.24) |
| PI-1 | S11 | 60 (24.19) | 40 (21.29) | 68 (21.04) |
| PI-1 | S12 | 62 (3.67) | 55 (2.34) | 90 (2.88) |
| PI-2 (4 wt%) | - | 35 (2.20) | 17 (0.59) | 22 (0.60) |
| PI-2 (5 wt%) | - | 45 (3.01) | 25 (1.22) | 35 (1.06) |
| PI-2 | S1 | 85 (2.82) | 95 (0.73) | 100 (0.57) |
| PI-2 | S2 | 50 (2.20) | 75 (1.40) | 100 (1.35) |
| PI-2 | S3 | 42 (2.34) | 77 (1.58) | 88 (1.65) |
| PI-2 | S4 | 45 (2.46) | 35 (1.24) | 60 (1.28) |
| PI-2 | S5 | 48 (2.30) | 37 (0.65) | 85 (1.46) |
| PI-2 | S6 | 48 (2.13) | 37 (1.45) | 85 (1.17) |
| PI-2 | S7 | 35 (7.35) | 17 (5.91) | 22 (6.31) |
| PI-2 | S8 | 70 (6.53) | 60 (5.69) | 99 (5.71) |
| PI-2 | S9 | 35 (2.84) | 17 (0.90) | 22 (1.44) |
| PI-2 | S10 | 35 (2.41) | 17 (0.61) | 22 (0.94) |
| PI-2 | S11 | n.m. | n.m. | n.m. |
| PI-2 | S12 | 35 (3.99) | 30 (1.91) | 45 (1.96) |
| PI-3 (4 wt%) | - | 40 (0.67) | 25 (0.92) | 30 (0.93) |
| PI-3 (5 wt%) | - | 55 (0.82) | 33 (0.62) | 45 (1.02) |
| PI-3 | S1 | 90 (0.45) | 100 (0.93) | 100 (1.00) |
| PI-3 | S8 | 55 (4.13) | 90 (5.88) | 100 (5.89) |
| PI-4 (4 wt%) | - | 26 (0.30) | not reactive | 11 (0.85) |
| PI-4 (5 wt%) | - | 32 (0.57) | 18 (0.54) | 30 (0.74) |
| PI-4 | S1 | 55 (0.59) | 42 (1.10) | 99 (0.78) |
| PI-4 | S8 | 50 (3.78) | 35 (6.24) | 40 (6.70) |
| PI-5 (4 wt%) | - | 30 (2.63) | 13 (2.19) | 24 (2.37) |
| PI-5 (5 wt%) | - | 55 (2.93) | 25 (2.52) | 45 (2.33) |
| PI-5 | S1 | 50 (2.42) | 90 (1.62) | 96 (1.02) |
| PI-5 | S8 | 50 (6.24) | 45 (6.80) | 93 (6.84) |

The following lamps were used in Table 2:

Lamp 1: a UV Hg lamp with an intensity of 120 W/cm.
Lamp 2: a UV LED lamp with a wavelength of 395 nm and an intensity of 16 W/$cm^2$.
Lamp 3: a UV LED lamp with a wavelength of 365 nm and an intensity of 16 W/$cm^2$.

As can be seen from the data presented in Table 2, thioalkylcoumarin-based photosensitizers having a formula according to Formula (I) improve the performance of each of the photoiniators employed, with especially impressive improvements seen for the inventive PI-2/PI-3/PI-4 + thioalkylcoumarin combinations, often vastly outperforming 5 wt.-% of the photoinitiator alone.

Furthermore, the photocured products employing the thioalkylcoumarin-based photosensitizers having a formula according to Formula (I) have significantly less yellowing than those produced using either the dialkylaminocoumarin S8 or the heterocycle-substituted thioalkylcoumarin S 11.

The performance of thioalkylcoumarin S1 was further tested against dialkylaminocoumarin S8 in the through-curing of black offset inks (with 4 wt% of PI-2 and 1 wt% of either S1 or S8 according to the through cure measurement method given in the determination methods), the results of which are shown in Table 3 (maximum through cure speed in m/min).

**Table 3** Performance of S 1 in combination with PI-2 in black offset ink.

| PI | S | Lamp 1 | Lamp 2 | Lamp 3 |
|---|---|---|---|---|
| PI-2 | S1 | 30 | 100 | 95 |
| PI-2 | S8 | 19 | 90 | 70 |

Thioalkylcoumarin S1 again considerably outperforms dialkylaminocoumarin S8.

## Claims

1. A photopolymerizable composition (PC) comprising:

   a) one or more ethylenically unsaturated, free-radical polymerizable compounds;
   b) one or more photoinitiators (PI);
   c) one or more photosensitizers (S) having a structure according to formula (I):

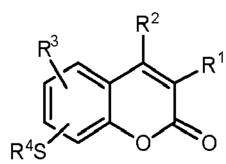

(I)

   wherein $R^1$ and $R^2$ are independently selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
   wherein $R^3$ represents from 0 to 3 substitutions, each being selected from the group consisting of hydrogen, halogen, $C_1$-$C_{10}$ alkyl, $C_6$-$C_{14}$ aryl, $OR^5$, $SR^5$, and $NR^5_2$, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
   wherein $R^4$ is selected from the group consisting of $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
   wherein at least one of $R^1$ and $R^2$ is not hydrogen, and
   wherein each instance of $R^1$ to $R^5$ may optionally be joined to one or more further instances of $R^1$ to $R^5$ to form one or more 5-membered or 6-membered rings.

2. The photopolymerizable composition (PC) according to claim 1, wherein at least one of the one or more photoinitiators (PI) is Norrish Type-I photoinitiator, more preferably at least one of the one or more photoinitiators (PI) is an acylphosphine oxide photoinitiator, more preferably at least one of the one or more photoinitiators (PI) is a

bisacylphosphine oxide photoinitiator.

**3.** The photopolymerizable composition (PC) according to any one of the preceding claims, wherein at least one of the one or more photoinitiators (PI) has a structure according to any one of formulae (III) to (VI):

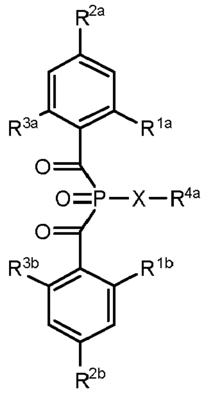

(III)

wherein each instance of $R^{1a}$, $R^{2a}$, $R^{3a}$, $R^{1b}$, $R^{2b}$ and $R^{3b}$ is independently selected from the group consisting of $C_1$-$C_4$ alkyl, $C_1$-$C_4$ alkoxy or halogen;
wherein X is selected from the group consisting of direct single bond, O, S, $NR^{5a}$, $-CH_2CO_2-$, and $-CH_2CH_2CO_2-$;
wherein $R^{4a}$ is selected from the group consisting of hydrogen, $(CO)R^{6a}$, $(CO)OR^{6a}$, $(CO)NR^{5a}R^{6a}$, $(SO_2)R^{6a}$, $[Si(R^{7a})(R^{8a})]_m$-$Si(R^{7a})(R^{8a})(R^{9a})$, $[Si(R^{7a})(R^{8a})O]_m$-$Si(R^{7a})(R^{8a})(R^{9a})$; or
wherein $R^{4a}$ is $C_1$-$C_{28}$ alkyl or $C_2$-$C_{28}$ alkyl which is interrupted by one or more O, $NR^{5a}$, S, (CO), (CO)O, or $SO_2$, wherein said $C_1$- $C_{28}$ alkyl or interrupted $C_2$-$C_{28}$ alkyl is unsubstituted or substituted by one or more substituents selected from the group consisting of OH, $C_6$-$C_{14}$ aryl, $[Si(R^{7a})(R^{8a})]_m$-$Si(R^{7a})(R^{8a})(R^{9a})$, $[Si(R^{7a})(R^{8a})$-$O]_m$-$Si(R^{7a})(R^{8a})(R^{9a})$, $N(R^{5a})_2$, 2-oxiranyl, $C_3$-$C_{12}$ cycloalkyl which is unsubstituted or substituted by $C_1$-$C_4$ alkyl, $C_1$-$C_4$ alkoxy or by OH, $C_3$-$C_{12}$ cycloalkyl which is interrupted by one or more O, $NR^{5a}$ or S and which interrupted $C_3$-$C_{12}$ cycloalkyl is unsubstituted or substituted by $C_1$-$C_4$ alkyl, $C_1$-$C_4$ alkoxy or by OH, and $C_6$-$C_{14}$ aryl which is unsubstituted or substituted by $C_1$-$C_4$alkyl, $C_1$-$C_4$ alkoxy or by OH; or
wherein $R^{4a}$ is $C_6$-$C_{10}$ aryl which is unsubstituted or substituted by one or more $C_1$- $C_{12}$ alkyl, $C_2$-$C_{20}$ alkyl which is interrupted by one or more O, $C_1$-$C_{12}$-alkoxy or by OH; or
wherein, in cases where X is $NR^{5a}$, $R^{4a}$ together with $R^{5a}$ and the N-atom forms a 5 or 6-membered saturated ring which is uninterrupted or interrupted by O or $NR^{5a}$ and which uninterrupted or interrupted ring is unsubstituted or substituted by one or more $C_1$-$C_4$alkyl, $C_1$-$C_4$ alkoxy or by OH; or
wherein $R^{4a}$ is selected from the group consisting of structures (A) to (G):

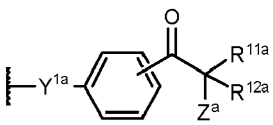

(A)

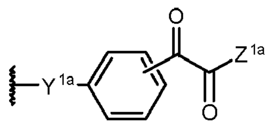

(B)

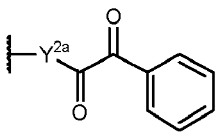

(C)

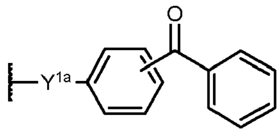

(D)

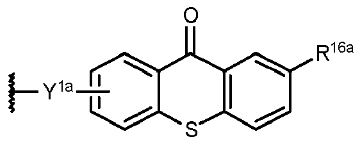

(E)

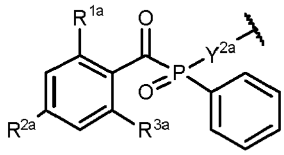

(F)

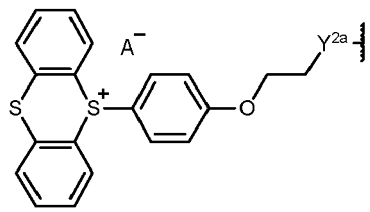

(G)

wherein all options for $R^{4a}$ may be further substituted by one or more groups, selected from OH and $R^{17a}$; wherein $R^{17a}$ is

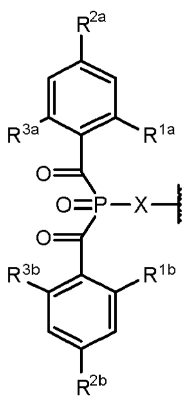

;

wherein A is $PF_6$, $SbF_6$, $AsF_6$ or $B(C_6F_5)_4$;
wherein $R^{5a}$ is hydrogen, $(CO)R^{6a}$, phenyl, $C_1$-$C_{12}$ alkyl, $C_2$-$C_{12}$ alkyl which is interrupted by one or more O, wherein said $C_1$-$C_{12}$ alkyl or interrupted $C_2$-$C_{12}$ alkyl is unsubstituted or substituted by one or more $C_3$-$C_7$ cycloalkyl, OH or by NCO, $C_3$-$C_{12}$ cycloalkyl which is unsubstituted or substituted by one or more $C_1$-$C_4$ alkyl, $C_1$-$C_4$ alkoxy, OH or by NCO;
wherein $R^{6a}$ is $C_1$-$C_{12}$ alkyl or $C_2$-$C_{12}$alkyl which is interrupted by one or more O, wherein said $C_1$-$C_{12}$ alkyl or interrupted $C_2$-$C_{12}$ alkyl is unsubstituted or substituted by one or more $C_3$-$C_7$ cycloalkyl, OH, NCO or by phenyl which is substituted by NCO; or
wherein $R^{6a}$ is $C_3$-$C_{12}$ cycloalkyl or $C_2$-$C_{10}$ alkenyl which is unsubstituted or substituted by one or more $C_1$-$C_4$ alkyl, OH or $C_1$-$C_4$ alkoxy; or
wherein $R^{6a}$ is $C_6$-$C_{14}$ aryl which is unsubstituted or substituted by $C_1$-$C_{12}$ alkyl, $C_1$-$C_{12}$ alkoxy, NCO or by NCO-substituted $C_1$-$C_{12}$ alkyl; or
wherein if the group $N(R^{5a})_2$ is present, then one instance of $R^{5a}$ may be $(CO)R^{6a}$, wherein the other instance of $R^{5a}$ and $R^{6a}$, together with the N and CO moieties form a 5- or 6-mebered ring, which is either uninterrupted or interrupted by O or $NR^{5a}$ and which uninterrupted or interrupted ring is either unsubstituted or substituted by one

or more $C_1$-$C_4$ alkyl, $C_1$-$C_4$ alkoxy, or by OH;
wherein $R^{7a}$, $R^{8a}$, and $R^{9a}$ are each independently selected from the group consisting of $C_1$-$C_4$ alkyl, $C_6$-$C_{14}$ aryl or $C_1$-$C_4$ alkoxy;
wherein m is an integer in the range from 0-10;
wherein $Y^{1a}$ is selected from the group consisting of a direct single bond, O, S, $NR^{5a}$ , O(CO)-* or $O(CO)CH_2O$-*, wherein the asterix denotes the bond to the phenyl ring of the group (A), (B), (D), or (E);
wherein $Y^{2a}$ is selected from the group consisting of a direct single bond, O, S or $NR^{5a}$;
wherein $R^{11a}$ and $R^{12a}$ independently of each other are $C_1$-$C_{10}$alkyl, $C_2$-$C_{10}$ alkenyl or phenyl, $C_1$-$C_4$ alkyl which is unsubstituted or substituted by $C_1$-$C_4$ alkyl, or $R^{11a}$ and $R^{12a}$ together with the C-atom to which they are attached form a cyclohexane or cyclopentane ring;
wherein $Z^a$ is OH or $NR^{13a}R^{14a}$ ;
wherein $Z^{1a}$ is $C_1$-$C_{12}$ alkoxy or $C_2$-$C_{12}$ alkoxy which is interrupted by one or more O, wherein said $C_1$-$C_{12}$ alkoxy or interrupted $C_2$-$C_{12}$ alkoxy is unsubstituted or substituted by OH; wherein $R^{13a}$ and $R^{14a}$ independently of each other are $C_1$-$C_{12}$ alkyl, $C_1$-$C_{12}$ alkyl which is substituted by one or more OH or halogen; or
wherein $R^{13a}$ and $R^{14a}$ together with the N- atom to which they are attached form a 5- or 6-membered unsaturated or saturated ring, which ring is uninterrupted or interrupted by O or $NR^{15a}$, wherein $R^{15a}$ is $C_1$-$C_4$ alkyl;
wherein $R^{16a}$ is hydrogen or $C_1$-$C_4$ alkyl; provided that

(i) if $R^{1a}$, $R^{2a}$ and $R^{3a}$ as $C_1$-$C_4$ alkyl are methyl and X is O, then $R^4$ as $C_1$-$C_{28}$ alkyl is not methyl, ethyl, n-propyl, 2-propyl, n-butyl, sec-butyl, tert-butyl, n-hexyl;
(ii) if $R^{1a}$ and $R^{3a}$ as halogen are Cl, $R^{2a}$ is hydrogen and X is O, then $R^{4a}$ as substituted $C_3$-$C_{10}$ aryl is not 4-butyl-phenyl; and
(iii) if $R^{1a}$ and $R^{3a}$ as $C_1$-$C_4$ alkoxy are methoxy, $R^{2a}$ is hydrogen and X is $NR^{5a}$, and $R^{4a}$ together with $R^{5a}$ and the N-atom forms a 5 or 6-membered saturated ring, then said ring is not a piperidine ring;

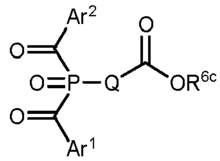

(IV)

wherein $Ar^1$ and $Ar^2$ are each independently

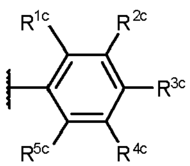

or naphthyl which is unsubstituted or substituted one or more times by $R^{1c}$, $R^{2c}$, $R^{3c}$, $R^{4c}$, or $R^{5c}$;
wherein $R^{1c}$ and $R^{5c}$ are each independently selected from the group consisting of $C_1$-$C_4$ alkyl, $C_1$-$C_4$ alkoxy or halogen;
wherein $R^{3c}$ is selected from the group consisting of hydrogen, $C_1$-$C_4$ alkyl, halogen, $C_1$-$C_4$ alkoxy or $C_2$-$C_{20}$ alkoxy which is interrupted by one or more O;
wherein Q is $C_1$-$C_4$ alkylene;
wherein $R^{2c}$ and $R^{4c}$ independently of each other are hydrogen or $PG^c$-$Y^c$-$Z^c$-$X^c$-;
wherein $PG^c$ is a polymerizable group or methyl or ethyl;
wherein $Y^c$ is a direct single bond, O or S;
wherein $X^c$ is a direct single bond, O or S;
wherein $Z^c$ is a direct single bond, $C_1$-$C_{20}$ alkylene or $C_2$-$C_{20}$ alkylene which is interrupted by one or more O;
wherein $R^{6c}$ is $C_3$-$C_{30}$ alkyl which is unsubstituted or substituted by one or more of the groups selected from OH and

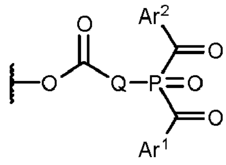

;

or

wherein $R^{6c}$ is $C_3$-$C_{28}$ alkyl which is interrupted by one or more O or $C_3$-$C_8$ cycloalkylene and which interrupted $C_3$-$C_{28}$ alkyl is unsubstituted or substituted by one or more of the groups selected from OH and

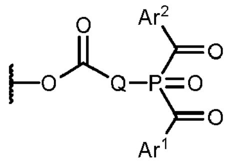

;

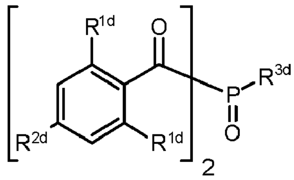

(V)

wherein $R^{1d}$ is $C_1$-$C_4$ alkyl, $C_1$-$C_4$ alkoxy or halogen;

wherein $R^{2d}$ is hydrogen, $C_1$-$C_4$ alkyl, $C_1$-$C_4$ alkoxy or halogen; and

wherein $R^{3d}$ is $C_1$-$C_{20}$ alkyl, cyclopentyl, cyclohexyl, phenyl-$C_1$-$C_4$ alkyl, naphthyl, biphenylyl or an O-, S- or N-containing 5- or 6-membered heterocyclic ring, the naphthyl, biphenylyl and O-, S- or N-containing 5- or 6-membered heterocyclic ring radicals being unsubstituted or substituted by $C_1$-$C_4$ alkyl, $C_1$-$C_4$ alkoxy, halogen, $C_1$-$C_4$ alkylthio; or

wherein $R^{3d}$ is

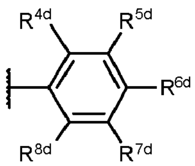

wherein $R^{4d}$, $R^{5d}$, $R^{6d}$, $R^{7d}$ and $R^{8d}$ are each independently selected from the group consisting of hydrogen, halogen, $C_1$-$C_{20}$ alkyl, cyclopentyl, cyclohexyl, $C_2$-$C_{12}$ alkenyl, $C_2$-$C_{20}$ alkyl interrupted by one or more non-consecutive O atoms, phenyl-$C_1$-$C_4$ alkyl, $C_1$-$C_{20}$ alkoxy, or phenyl that is unsubstituted or substituted by one or two $C_1$-$C_4$ alkyl or/and $C_1$-$C_4$ alkoxy substituents; and

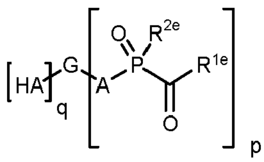

(VI)

wherein each A represents independently of one another O, S, $NR^{3e}$;

wherein G is a residue of the multifunctional compound (core) G-$(A\text{-}H)_{p+q}$, wherein each A-H represents an alcoholic or amino or thiol group;

wherein p and q are both integer numbers, p+q is an integer in the range from 3 to 10, and p is an integer in the range from 3 to 8;

wherein $R^{1e}$ and $R^{2e}$ are each independently selected from the group consisting of $C_1$-$C_{18}$ alkyl, $C_6$-$C_{12}$ aryl and $C_5$-$C_{12}$ cycloalkyl, each of which is uninterrupted or interrupted by one or more oxygen and/or sulfur atoms and/or

one or more substituted or unsubstituted amino groups, or are a five- to six-membered heterocyclyl containing oxygen and/or nitrogen and/or sulfur atoms; where each of said groups may be substituted by aryl, alkyl, aryloxy, alkoxy, heteroatoms and/or heterocyclic radicals; $R^{2e}$ may also be (CO)$R^{1e}$; and
wherein $R3^e$ is hydrogen or $C_1$-$C_4$ alkyl.

**4.** The photopolymerizable composition (PC) according to any one of the preceding claims, wherein at least one of the one or more photosensitizers (S), preferably each of the one or more photosensitizers (S), has a structure according to formula (II):

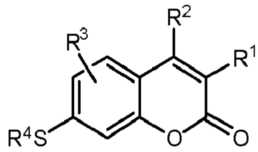 (II)

wherein $R^1$, $R^2$, $R^3$, and $R^4$ are each as defined for formula (I).

**5.** The photopolymerizable composition (PC) according to any one of the preceding claims, wherein $R^1$ is selected from the group consisting of hydrogen and $C_6$-$C_{14}$ aryl, wherein the $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl, more preferably $R^1$ is phenyl, wherein the phenyl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl, most preferably $R^1$ is unsubstituted phenyl.

**6.** The photopolymerizable composition (PC) according to any one of the preceding claims, wherein $R^2$ is selected from the group consisting of hydrogen and unsubstituted $C_1$-$C_{10}$ alkyl, more preferably $R^2$ is hydrogen.

**7.** The photopolymerizable composition (PC) according to any one of the preceding claims, wherein $R^3$ represents no substitutions.

**8.** The photopolymerizable composition (PC) according to any one of the preceding claims, wherein $R^4$ is $C_1$-$C_{10}$ alkyl, wherein the $C_1$-$C_{10}$ alkyl may be unsubstituted or substituted by one or more substituents selected from the group consisting of $OR^5$, $SR^5$, and $NR^5_2$, wherein each instance of $R^5$ is independently selected from the group consisting of hydrogen, and $C_1$-$C_{10}$ alkyl, more preferably $R^4$ is unsubstituted $C_1$-$C_{10}$ alkyl.

**9.** The photopolymerizable composition (PC) according to any one of the preceding claims, wherein at least one of, preferably all of, the photosensitizers (S) having a structure according to formula (I) is/are selected from the group consisting of:

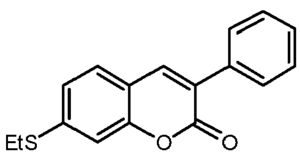 , 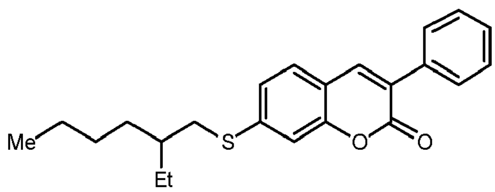 ,

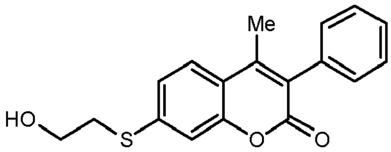 , 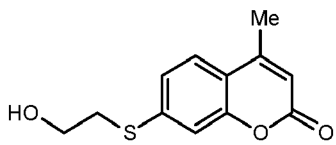 ,

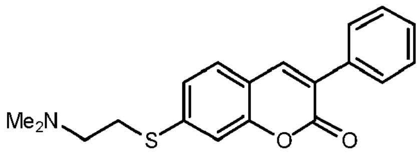, 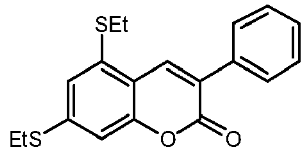,

and

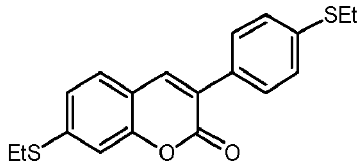.

**10.** The photopolymerizable composition (PC) according to any one of the preceding claims, comprising:

a) an amount in the range from 30 to 99.0 wt.-%, more preferably in the range from 50 to 95.0 wt.-%, most preferably in the range from 70 to 90 wt.-%, relative to the total weight of the photopolymerizable composition, of the one or more ethylenically unsaturated, free-radical polymerizable compounds;
b) an amount in the range from 0.5 to 20.0 wt.-%, more preferably in the range from 0.8 to 10.0 wt.-%, most preferably in the range from 1.0 to 5.0 wt.-%, relative to the total weight of the photopolymerizable composition, of the one or more photoinitiators (PI);
c) an amount in the range from 0.1 to 10.0 wt.-%, more preferably in the range from 0.3 to 5.0 wt.-%, most preferably in the range from 0.5 to 3.0 wt.-%, relative to the total weight of the photopolymerizable composition, of the one or more photosensitizers (S) having a structure according to formula (I).

**11.** The photopolymerizable composition (PC) according to any one of the preceding claims, which further comprises one or more, of the following components:

d) an amount in the range from 0.1 to 10.0 wt.-%, more preferably in the range from 0.3 to 5.0 wt.-%, most preferably in the range from 0.5 to 3.0 wt.-% of one or more further photosensitizers having a structure other than formula (I);
e) an amount in the range from 0.1 to 10.0 wt.-%, more preferably in the range from 0.3 to 5.0 wt.-%, most preferably in the range from 0.5 to 3.0 wt.-% of one or more amines;
f) an amount in the range from 0.1 to 30 wt.-%, more preferably in the range from 1.0 to 25 wt.-%, most preferably in the range from 10 to 20 wt.-%, relative to the total weight of the photopolymerizable composition, of one or more pigments;
g) an amount in the range from 5.0 to 60 wt.-%, more preferably in the range from 8.0 to 50 wt.-%, most preferably in the range from 10 to 40 wt.-%, relative to the total weight of the photopolymerizable composition, of one or more binders; and
h) an amount in the range from 0.01 to 10 wt.-%, more preferably in the range from 0.01 to 8.0 wt.-%, most preferably in the range from 0.01 to 5.0 wt.-%, relative to the total weight of the photopolymerizable composition, of one or more additives.

**12.** A compound selected from the group consisting of:

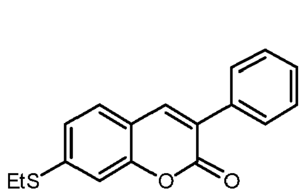, 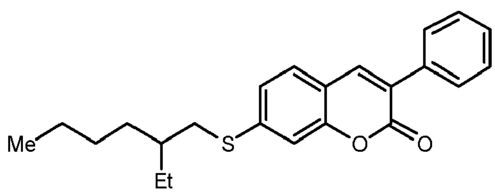,

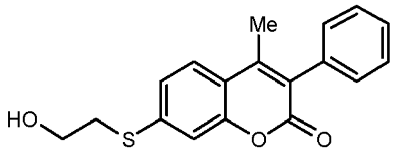, 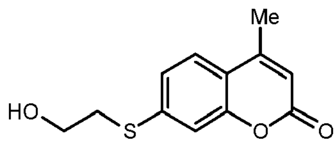,

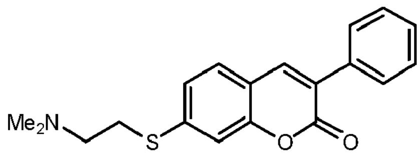, 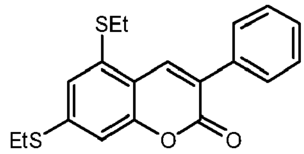,

and

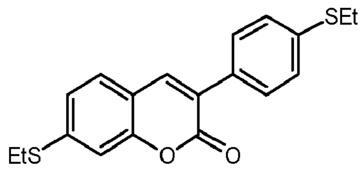.

**13.** A method for photocuring photopolymerizable compositions, coatings, adhesives and inks, said method comprising the following steps in the given order:

a) coating or printing the photopolymerizable composition (PC) according to any one of claims 1 to 11 onto a substrate, and
b) photopolymerizing said coated or printed composition with a light source on said substrate.

**14.** Use of a compound having a structure according to formula (I):

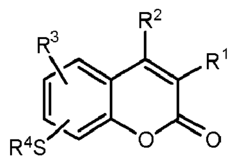 (I)

wherein $R^1$ and $R^2$ are independently selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein $R^3$ represents from 0 to 3 substitutions, each being selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein $R^4$ is selected from the group consisting of $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,
wherein at least one of $R^1$ and $R^2$ is not hydrogen, and
wherein each instance of $R^1$ to $R^5$ may optionally be joined to one or more further instances of $R^1$ to $R^5$ to form one or more 5-membered or 6-membered rings,
for improving the performance of one or more Norrish Type-I photoinitiators.

**15.** Use of one or more Norrish Type-I photoinitiators in combination with one or more compounds having a structure

according to formula (I):

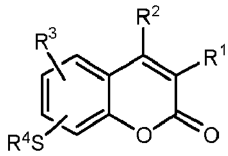
(I)

wherein $R^1$ and $R^2$ are independently selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,

wherein $R^3$ represents from 0 to 3 substitutions, each being selected from the group consisting of hydrogen, halogen, $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,

wherein $R^4$ is selected from the group consisting of $C_1$-$C_{10}$ alkyl, and $C_6$-$C_{14}$ aryl, wherein the $C_1$-$C_{10}$ alkyl, and $C_6$-$C_{14}$ aryl may be unsubstituted or substituted by one or more substituents selected from the group consisting of halogen, $C_1$-$C_{10}$ alkyl, and $C_6$-$C_{14}$ aryl, $OR^5$, $SR^5$, and $NR^5_2$, wherein each instance of $R^5$ is independently selected from the group consisting of hydrogen, $C_1$-$C_{10}$ alkyl, and $C_6$-$C_{14}$ aryl,

wherein at least one of $R^1$ and $R^2$ is not hydrogen, and

wherein each instance of $R^1$ to $R^5$ may optionally be joined to one or more further instances of $R^1$ to $R^5$ to form one or more 5-membered or 6-membered rings,

in the production of printing inks, screen-printing inks, gravure printing inks, solder masks, etch offset-printing inks, flexographic- printing inks, gravure printing inks, ink jet inks, resist material, insulators, encapsulants, image-recording material, solder mask, passivation layer, protective coating, 3D-printing objects and molds, holographic applications, optical fiber coating, waveguide and lens, overprint varnish, wood, vinyl, metal and plastic coatings.

Europäisches Patentamt
European Patent Office
Office européen des brevets

# EUROPEAN SEARCH REPORT

Application Number
EP 23 22 0773

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2021/070131 A1 (IGM RESINS ITALIA SRL [IT]) 15 April 2021 (2021-04-15)<br>* page 1, line 6 - line 7 *<br>* claims 1-14 *<br>* examples 1-3 *<br>* page 15 - page 16 *<br>----- | 1-15 | INV.<br>G03F7/031<br>G03F7/029<br>C08F2/50 |
| A | WO 2023/214013 A1 (IGM GROUP B V [NL]) 9 November 2023 (2023-11-09)<br>* page 1, line 7 - line 10 *<br>* claims 1-15 *<br>* examples *<br>----- | 1-15 | |
| X<br><br>A | CN 105 153 142 A (UNIV FUDAN) 16 December 2015 (2015-12-16)<br>* compound 7c;<br>paragraph [0027] *<br>----- | 12<br><br>1-11,<br>13-15 | |
| X<br><br>A | US 3 547 952 A (SARKAR ASIM KUMAR) 15 December 1970 (1970-12-15)<br>* example 2 *<br>----- | 12<br><br>1-11,<br>13-15 | TECHNICAL FIELDS SEARCHED (IPC)<br>G03F<br>C08F |

The present search report has been drawn up for all claims

1

| Place of search | Date of completion of the search | Examiner |
|---|---|---|
| Munich | 5 June 2024 | Borowczak, Baptiste |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................
& : member of the same patent family, corresponding document

EPO FORM 1503 03.82 (P04C01)

## ANNEX TO THE EUROPEAN SEARCH REPORT ON EUROPEAN PATENT APPLICATION NO. EP 23 22 0773

This annex lists the patent family members relating to the patent documents cited in the above-mentioned European search report.
The members are as contained in the European Patent Office EDP file on
The European Patent Office is in no way liable for these particulars which are merely given for the purpose of information.

05-06-2024

| Patent document cited in search report | Publication date | Patent family member(s) | Publication date |
|---|---|---|---|
| WO 2021070131 A1 | 15-04-2021 | CN 114502601 A | 13-05-2022 |
| | | EP 4041779 A1 | 17-08-2022 |
| | | JP 2022551640 A | 12-12-2022 |
| | | US 2022340691 A1 | 27-10-2022 |
| | | WO 2021070131 A1 | 15-04-2021 |
| WO 2023214013 A1 | 09-11-2023 | NONE | |
| CN 105153142 A | 16-12-2015 | NONE | |
| US 3547952 A | 15-12-1970 | BE 712552 A | 23-09-1968 |
| | | CH 460568 A4 | 14-08-1970 |
| | | CH 501090 A | 14-08-1970 |
| | | DE 1768026 A1 | 16-12-1971 |
| | | FR 1565731 A | 02-05-1969 |
| | | GB 1154272 A | 04-06-1969 |
| | | NL 6804480 A | 30-09-1968 |
| | | US 3547952 A | 15-12-1970 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20170240659 A
- EP 2909243 A
- WO 2017216699 A
- EP 126541 A
- GB 2339571 A
- US 4950581 A
- GB 2348644 A
- US 4450598 A
- US 4136055 A
- WO 0010972 A
- WO 0026219 A
- EP 2011069514 W
- US 9938231 B
- WO 2013164394 A
- US 3844916 A
- EP 280222 A
- US 5482649 A
- US 5734002 A
- US 20130012611 A
- EP 245639 A
- US 5534559 A

### Non-patent literature cited in the description

- *CHEMICAL ABSTRACTS*, 162881-26-7
- *CHEMICAL ABSTRACTS*, 75980-60-8
- *CHEMICAL ABSTRACTS*, 84434-11-7
- *CHEMICAL ABSTRACTS*, 145052-34-2
- *CHEMICAL ABSTRACTS*, 91-44-1